# EUROPEAN PATENT APPLICATION

(11) **EP 4 099 412 A1**
(43) Date of publication of application: **07.12.2022**
(21) Application number: 21177594.5
(22) Date of filing: 03.06.2021
(51) Int. Cl.: H01L 51/00, H01L 51/50

(54) **AN ORGANIC ELECTROLUMINESCENT DEVICE AND A COMPOUND FOR USE THEREIN**

(71) Applicant: Novaled GmbH, 01099 Dresden (DE)
(72) Inventor: LANGGUTH, Oliver, 01099 Dresden (DE); PARK, Moo Jin, 01099 Dresden (DE); UVAROV, Vladimir, 01099 Dresden (DE)
(74) Representative: Bittner, Thomas L.

(57) **Abstract**

The present invention relates to an organic electroluminescent device comprising an anode layer, a cathode layer, a hole injection layer, at least one light-emitting layer and an organic semiconductor layer; wherein the organic semiconductor layer is arranged between the hole injection layer and the at least one light-emitting layer; wherein the organic semiconductor layer comprises a compound of formula (1) 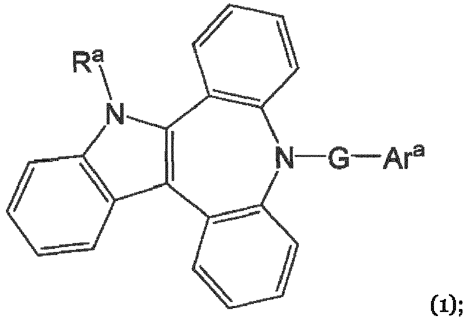 and a respective compound.

## Description

### TECHNICAL FIELD

The present invention relates to an organic electroluminescent device and a compound for use therein.

### BACKGROUND ART

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, an emission layer EML, an electron transport layer ETL, and a cathode layer, which are sequentially stacked on a substrate. In this regard, the HIL, the HTL, the EML, and the ETL are thin films formed from organic compounds.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has low operating voltage, excellent efficiency and/or a long lifetime.

WO 2016/16013894 A2 relates to an organic compound and an organic electroluminescent device comprising the same. The organic compound is used in an organic material layer of an organic electroluminescent device.

US 2019/355912 A1 relates to an organic electroluminescent device. The organic electroluminescent device comprises a specific combination of a light-emitting layer and an electron transport zone.

US 2017/179397 A1 discloses an organic light-emitting device including a first compound and a second compound having a predetermined formula.

WO 2020/096012 A1 discloses an organic electroluminescent element which comprises a cathode, an anode, and organic layers disposed between the cathode and the anode, wherein the organic layers comprise a luminescent layer and an electron-transporting layer, the electron-transporting layer having been disposed between the cathode and the luminescent layer, the luminescent layer comprising a specific first compound and the electron-transporting layer comprising a second compound.

US 2019/067591 A1 discloses an organic light emitting device.

US 2019/194219 A1 discloses an organic electroluminescent element which is provided with a positive electrode, a negative electrode and a light emitting layer arranged between the positive electrode and the negative electrode, and wherein the light emitting layer contains a two specific compounds.

There is still a need for new hole transport materials as well as electron blocking materials for improving the performance of OLEDs in particular improved operating voltage, and/or current efficiency and/or stability in particular improved lifetime and/or improved operating voltage stability over time.

### DISCLOSURE

### Organic electroluminescent device

An aspect of the present invention provides an organic electroluminescent device comprising an anode layer, a cathode layer, a hole injection layer, at least one light-emitting layer and an organic semiconductor layer; wherein the organic semiconductor layer is arranged between the hole injection layer and the at least one light-emitting layer;
wherein
the organic semiconductor layer comprises a compound of formula (1) 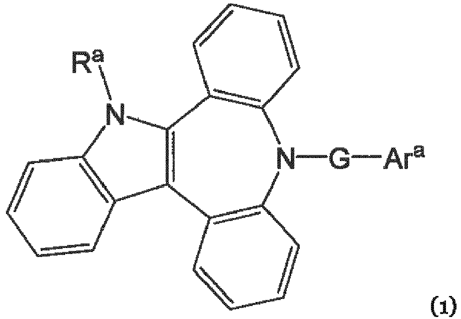
- R^{a} is selected from a substituted or unsubstituted C₆ to C₁₈ aryl, or a substituted or unsubstituted C₁ to C₁₈ alkyl;
- G is selected from a substituted or unsubstituted C₆ to C₁₂ aryl, wherein the C₆ to C₁₂ aryl can be a biaryl, such as biphenylene, or a condensed aryl, such as napthylene;
- Ar^{a} is selected from a substituted or unsubstituted C₁₃ to C₂₄ aryl comprising o to 3 fused rings; a group of formula (2a); or a group of formula (2b); 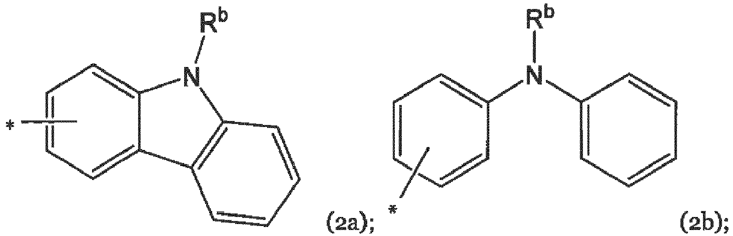
- R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl; and
- the hole injection layer comprises hole injection material and a matrix material.

In the present specification, the term "hole injection material" refers to a material capable of facilitating hole injection (i.e.) positive charges injected from an anode preferably into an organic layer in particular into a hole transport layer, and wherein said material is capable of reducing the operational voltage at a certain current density if present. The hole injection material can be a metal compound, or organic compound as an organic p-dopant. The organic p-dopant or the metal compound may provide a hole injection from anodes into hole transport matrices, without substantially increasing the concentration of the free charge carriers above the level which corresponds to conductivities observed in a neat matrix or may capable of increasing the density of positive charge carriers in a hole transport material or hole transport layer, when added to a semiconductor.

It should be noted that throughout the application and the claims any Rⁿ, Mⁿ, etc. always refer to the same moieties, unless otherwise noted.

In the present specification, the term "ligand" refers to an anionic molecule which binds to a cationic metal either by a dative bond or ionic interaction, preferably a dative bond, wherein the nature of the dative bond can have a character ranging from a covalent bond to an ionic bond.

In the present specification, when a definition is not otherwise provided, "partially fluorinated" refers to an alkyl group, an aryl group, a heteroaryl group etc. in which only part of the hydrogen atoms are replaced by fluorine atoms.

In the present specification, when a definition is not otherwise provided, "perfluorinated" refers to an alkyl group, an aryl group, a heteroaryl group etc. in which all hydrogen atoms are replaced by fluorine atoms.

Unless otherwise noted the term "metal" as used herein includes metal cations if the metal is referred to together with an anion, wherein the positive charge of the metal cation and the negative charge of the anion balance each other.

In the present specification, an electron withdrawing group (EWG) is a group that reduces electron density in a molecule through the carbon atom it is bonded to. Typical examples of electron withdrawing groups are halogen, in particular F and Cl, -COR, -COH, -COOR, -COOH, partially fluorinated or perfluorinated alkyl, partially fluorinated or perfluorinated aryl, partially fluorinated or perfluorinated heteroaryl, partially fluorinated or perfluorinated carbocyclyl, partially fluorinated or perfluorinated C₂ to C₂₀ heterocyclyl, -NO₂, and -CN.

In the present specification, when a definition is not otherwise provided, "substituted" refers to one substituted with a deuterium, C₆ to C₁₂ aryl, C₃ to C₁₁ heteroaryl, and C₁ to C₁₂ alkyl, D, C₁ to C₁₂ alkoxy, C₃ to C₁₂ branched alkyl, C₃ to C₁₂ cyclic alkyl, C₃ to C₁₂ branched alkoxy, C₃ to C₁₂ cyclic alkoxy, partially or perfluorinated C₁ to C₁₂ alkyl, partially or perfluorinated C₁ to C₁₂ alkoxy, partially or perdeuterated C₁ to C₁₂ alkyl, partially or perdeuterated C₁ to C₁₂ alkoxy, halogen, CN or PY(R¹⁰)₂, wherein Y is selected from O, S or Se, preferably O and R¹⁰ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an iso-propyl group, a butyl group, an iso-butyl group, a tert-butyl group, a pentyl group, a hexyl group.

In the context of the present invention, "ⁱCnH₍₂ₙ₊₁₎" denotes an iso-alkyl group and "ⁱCₙF₍₂ₙ₊₁₎" denotes a perfluorinated iso-alkyl group.

The term "carbocyclyl" as used herein includes all types of not fully saturated organic ringsystems, for example, cycloalkyl, partially unsaturated cycloalkyl etc. monocycles, bicycles, fused ring systems, bridged ring systems, and spirocyclic ring systems are included.

The term "heterocyclyl" as used herein refers to a heterocarbocyclyl.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms.

In the present specification, the single bond refers to a direct bond.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms anode, anode layer and anode electrode are used synonymously.

The terms cathode, cathode layer and cathode electrode are used synonymously.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The different embodiments described herein may separately or in combination of two or more embodiments be material for realizing the invention. That is, features of two or more different embodiments may be combined with each other in accordance with the invention.

### Advantageous Effects

Surprisingly, it was found that the use of an organic semiconductor layer comprising a compound of formula (1) in an OLED between the hole injection layer and the at least one light-emitting layer, for example in a hole transport layer or a electron blocking layer, is helpful to improve the performance of the device, such as operational voltage, voltage stability, light emitting efficiency, lifetime, etc.

### Compound of formula (1) in the organic semiconductor layer

According to one embodiment of the present invention, the mass of the compound of formula (1) is less than 810 g/mol, preferably less than 800 g/mol, more preferably less than 780 g/mol, and most preferably less than 770 g/mol.

### R^{a}

According to one embodiment of the present invention, R^{a} is selected from a substituted or unsubstituted C₆ to C₁₂ aryl, alternatively a substituted or unsubstituted C₆ to C₁₀ aryl; or a substituted or unsubstituted C₁ to C₁₈ alkyl, alternatively a substituted or unsubstituted C₁ to C₁₂ alkyl, alternatively a substituted or unsubstituted C₁ to C₁₀ alkyl, alternatively a substituted or unsubstituted C₁ to C₈ alkyl, alternatively a substituted or unsubstituted C₁ to C₆ alkyl, alternatively a substituted or unsubstituted C₁ to C₄ alkyl.

According to one embodiment of the present invention, R^{a} is selected from an unsubstituted C₆ to C₁₂ aryl, or an unsubstituted C₁ to C₄ alkyl.

According to one embodiment of the present invention, R^{a} is selected from an unsubstituted C₆ to C₁₈ aryl, or an unsubstituted C₁ to C₁₈ alkyl.

According to one embodiment of the present invention, R^{a} is selected from an unsubstituted C₆ to C₁₂ aryl, alternatively an unsubstituted C₆ to C₁₀ aryl; or an unsubstituted C₁ to C₁₈ alkyl, alternatively an unsubstituted C₁ to C₁₂ alkyl, alternatively an unsubstituted C₁ to C₁₀ alkyl, alternatively an unsubstituted C₁ to C₈ alkyl, alternatively an unsubstituted C₁ to C₆ alkyl, alternatively an unsubstituted C₁ to C₄ alkyl.

According to one embodiment of the present invention, R^{a} is selected from

| | | |
|---|---|---|
| 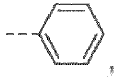 | 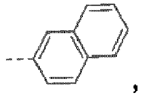 | 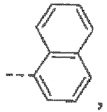 |
| 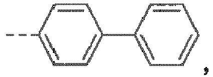 | 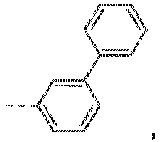 | 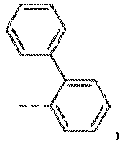 |
| 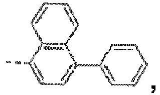 | 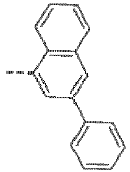 | 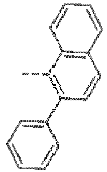 |
| 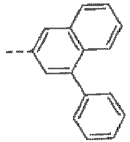 | 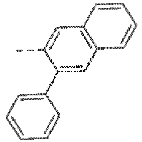 | 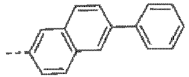 |
| 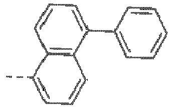 | 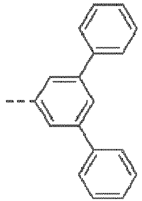 | 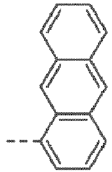 |
| 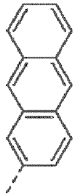 | 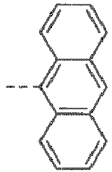 | 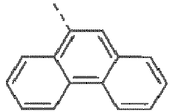 |
| -CH₃ | -C₂H₅ | -C₃H₇ |
| -C(CH₃)₂ | -C₄H₉ | -C(CH₃)₃ |
| -CH(CH₃)(C₂H₅) | | |

According to one embodiment of the present invention, R^{a} is selected from

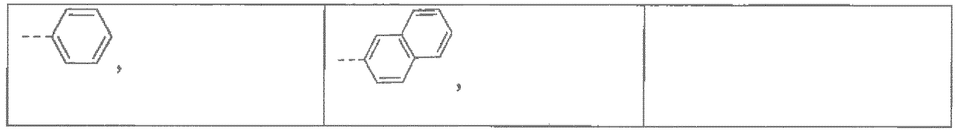

### G

According to one embodiment of the present invention, G is selected from a substituted or unsubstituted C₆ to C₁₂ aryl, wherein, if G is substituted, the one or more substituents are independently selected from C₁ to C₁₂ alkyl, C₆ to C₁₂ aryl or C₃ to C₁₂ heteroaryl.

According to one embodiment of the present invention, G is selected from an unsubstituted C₆ to C₁₂ aryl, wherein the C₆ to C₁₂ aryl can be a biaryl, such as biphenylene, or a condensed aryl, such as napthylene.

According to one embodiment of the present invention, G is selected from a substituted or unsubstituted C₆ to C₁₂ aryl. According to one embodiment of the present invention, G is selected from an unsubstituted C₆ to C₁₂ aryl.

In case that the aryl in G is substituted, the one or more substituents can be selected independently from C₁ to C₁₈ alkyl, C₆ to C₁₂ aryl or C₃ to C₁₂ heteroaryl. Alternatively in case that the aryl in G is substituted, the one or more substituents can be selected independently from C₁ to C₁₈ alkyl or C₆ to C₁₂ aryl. Alternatively in case that the aryl in G is substituted, the one or more substituents can be selected independently from C₁ to C₁₈ alkyl or C₆ to C₁₀ aryl. Alternatively in case that the aryl in G is substituted, the one or more substituents can be selected independently from C₁ to C₁₈ alkyl or phenyl. Alternatively in case that the aryl in G is substituted, the one or more substituents can be selected independently from C₁ to C₁₂ alkyl, alternatively C₁ to C₁₀ alkyl, alternatively C₁ to C₈ alkyl, alternatively C₁ to C₆ alkyl, alternatively C₁ to C₄ alkyl.

According to one embodiment of the present invention, G is selected from

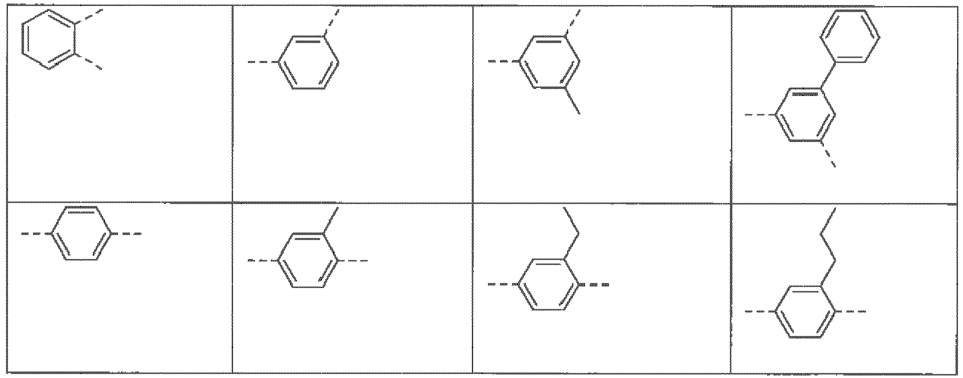

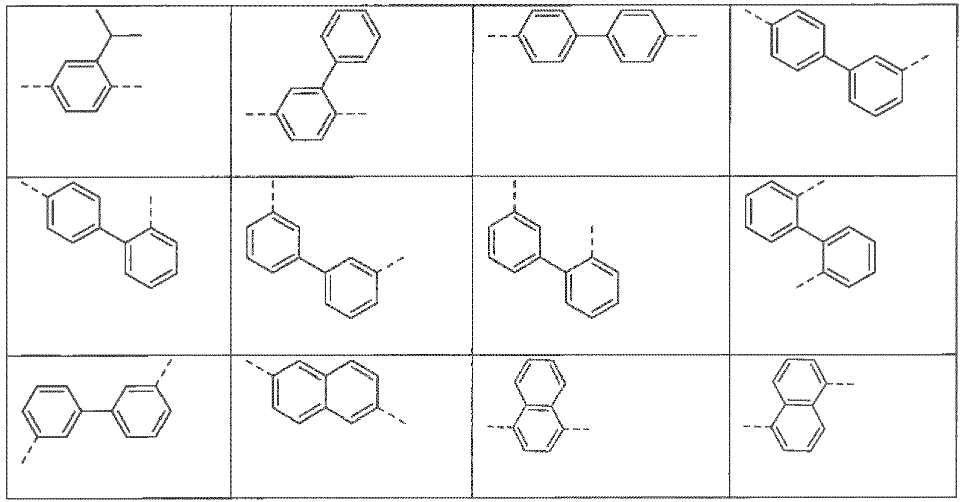

According to one embodiment of the present invention, G is selected from

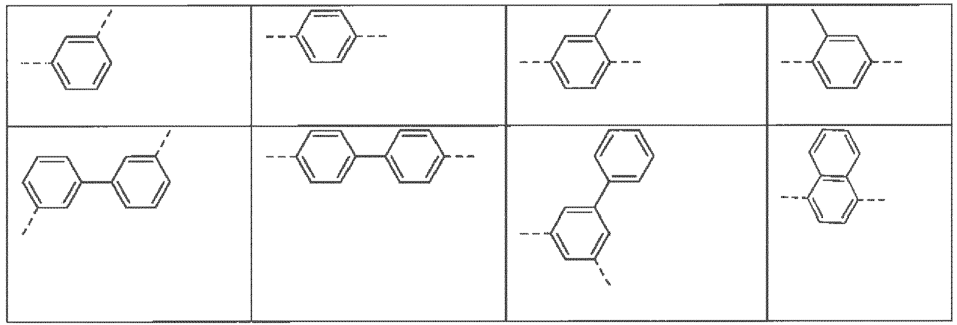

According to one embodiment of the present invention, G is selected from

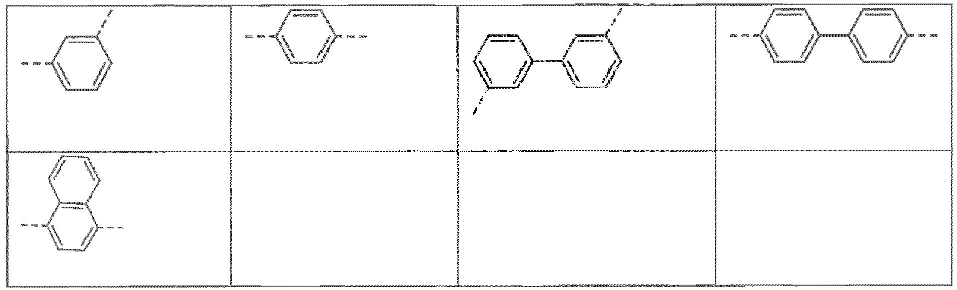

According to one embodiment of the present invention, G is selected from an unsubstituted C₆ to C₁₂ aryl.

### Ar^{a}

According to one embodiment of the present invention, Ar^{a} is selected from
- a substituted or unsubstituted C₁₃ to C₁₈ aryl comprising o to 3 fused rings, wherein, if the C₁₃ to C₁₈ aryl comprising o to 3 fused rings is substituted, the one or more substituents are independently selected from C₁ to C₁₂ alkyl, C₆ to C₁₂ aryl or C₃ to C₁₂ heteroaryl; or
- a group of formula (2a); or a group of formula (2b); 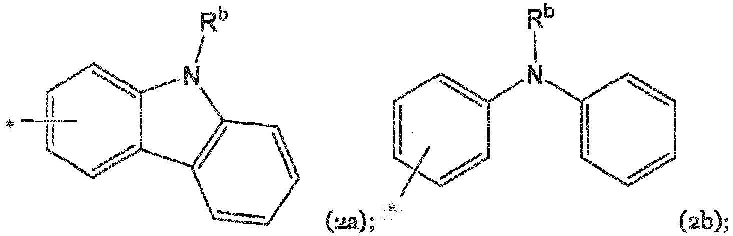 wherein in formula (2a) and (2b) R^{b} is selected from an unsubstituted C₆ to C₁₈ aryl; or an unsubstituted C₁ to C₄ alkyl.

According to one embodiment of the present invention, Ar^{a} is selected from a substituted or unsubstituted C₁₃ to C₂₄ aryl comprising o to 3 fused rings; or a group of formula (2a); 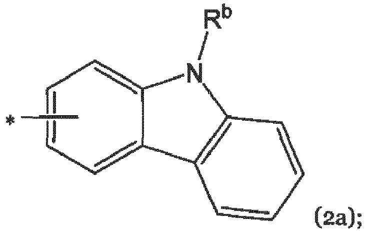 wherein in formula (2a) R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl.

According to one embodiment of the present invention, Ar^{a} is selected from
- a substituted or unsubstituted C₁₃ to C₁₈ aryl comprising o to 3 fused rings, wherein, if the C₁₃ to C₁₈ aryl comprising o to 3 fused rings is substituted, the one or more substituents are independently selected from C₁ to C₁₂ alkyl, C₆ to C₁₂ aryl or C₃ to C₁₂ heteroaryl; or
- a group of formula (2a); 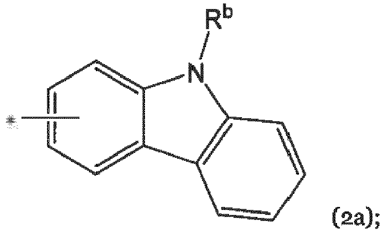 wherein in formula (2a) R^{b} is selected from an unsubstituted C₆ to C₁₈ aryl; or an unsubstituted C₁ to C₄ alkyl.

If Ar^{a} is substituted or unsubstituted aryl comprising o to 3 fused rings, the aryl may be C₁₃ to C22 aryl, alternatively C₁₃ to C₂₀ aryl, alternatively C₁₃ to C₁₈ aryl.

In case that the aryl in Ar^{a} is substituted, the one or more substituents can be selected independently from C₁ to C₁₈ alkyl, C₆ to C₁₂ aryl or C₃ to C₁₂ heteroaryl. In case that the aryl in Ar^{a} is substituted, the one or more substituents can be selected independently from C₁ to C₁₈ alkyl and C₆ to C₁₂ aryl. In case that the aryl in Ar^{a} is substituted, the one or more substituents can be selected independently selected from C₁ to C₁₂ alkyl, alternatively C₁ to C₁₀ alkyl, alternatively C₁ to C₈ alkyl, alternatively C₁ to C₆ alkyl, alternatively C₁ to C₄ alkyl.

According to one embodiment of the present invention, Ar^{a} is selected from

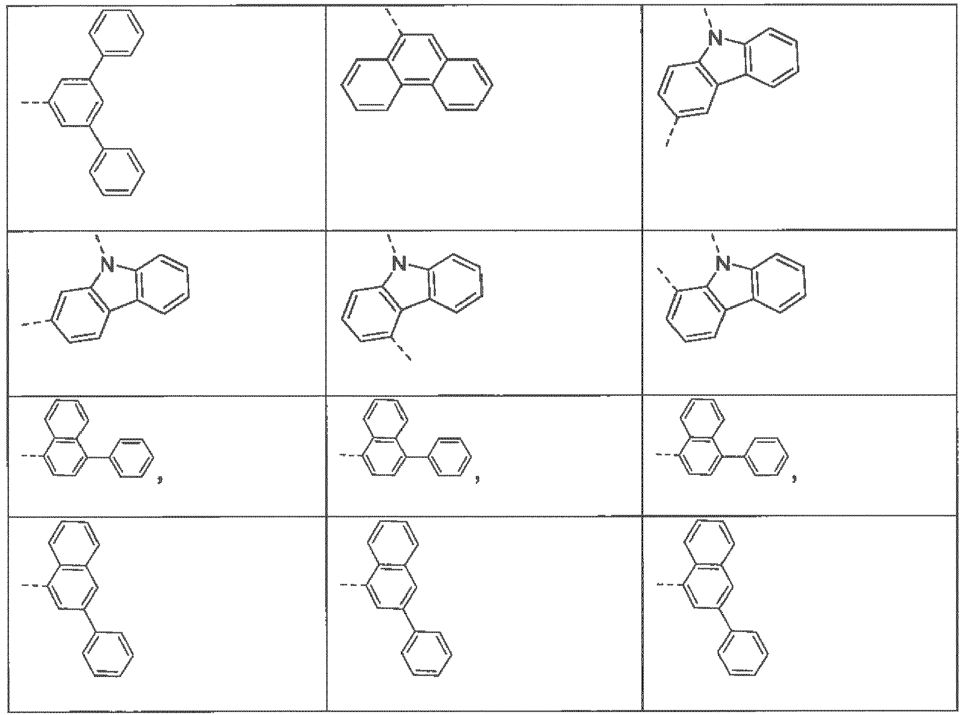

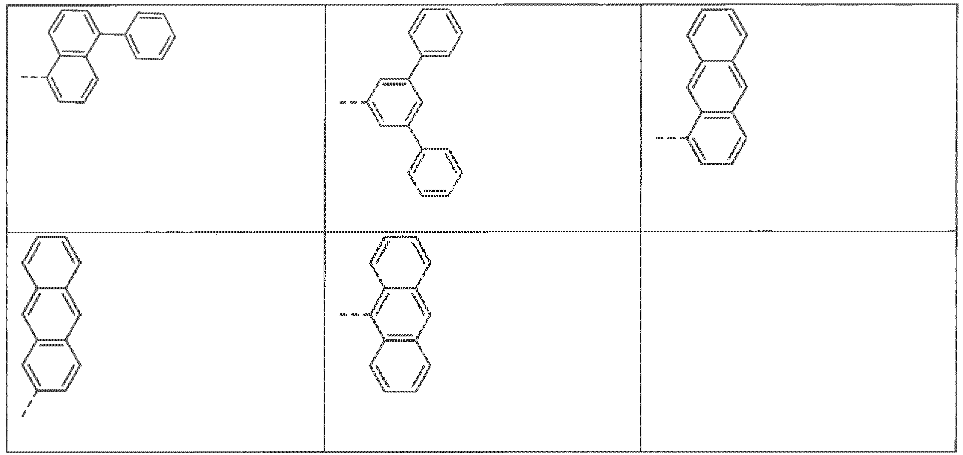

According to one embodiment of the present invention, Ar^{a} is selected from

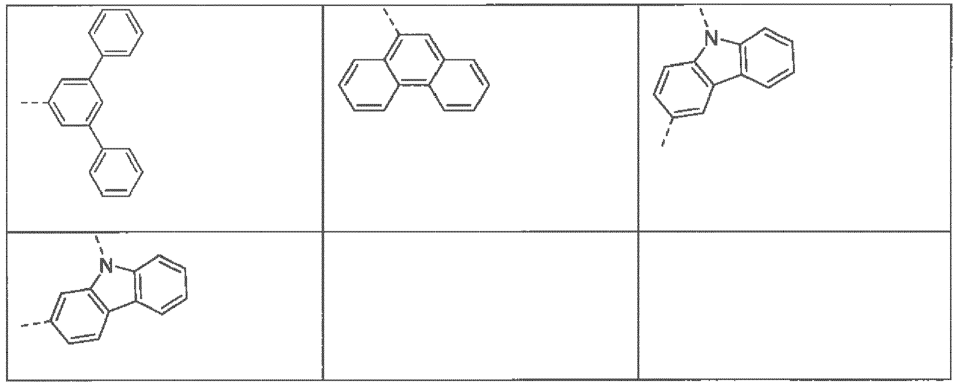

In the above tables, the dashed lines represent the binding positions to the remaining structure of formula (1).

### R^{b}

According to one embodiment of the present invention, R^{b} is selected from a substituted or unsubstituted C₆ to C₃₆ aryl; or a substituted or unsubstituted C₁ to C₁₈ alkyl.

According to one embodiment of the present invention, R^{b} is selected from a substituted or unsubstituted C₆ to C₂₄ aryl, alternatively C₆ to C₁₈ aryl; or a substituted or unsubstituted C₁ to C₁₂ alkyl, alternatively C₁ to C₁₀ alkyl, alternatively C₁ to C₈ alkyl, alternatively C₁ to C₆ alkyl, alternatively C₁ to C₄ alkyl.

According to one embodiment of the present invention, R^{b} is selected from

| | | |
|---|---|---|
| 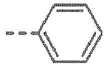 | 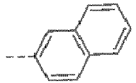 | 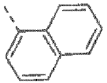 |
| 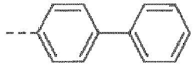 | 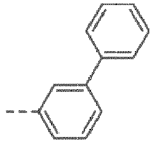 | 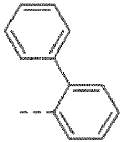 |
| -CH₃ | -C₂H₅ | -C₃H₇ |
| -C(CH₃)₂ | -C₄H₉ | -C(CH₃)₃ |
| -CH(CH₃)(C₂H₅) | | |

According to one embodiment of the present invention, R^{b} is selected from

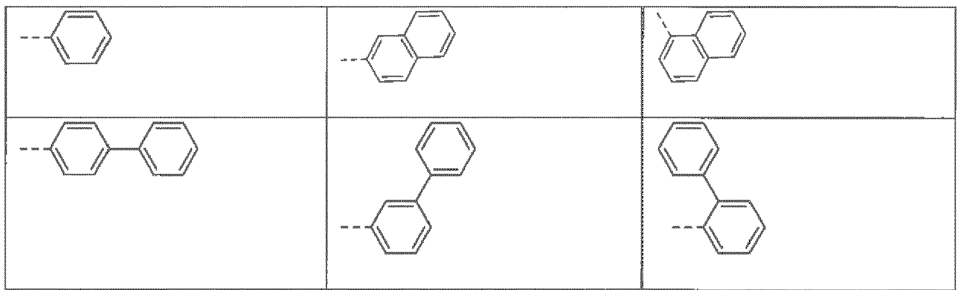

According to one embodiment of the present invention, R^{b} is selected from

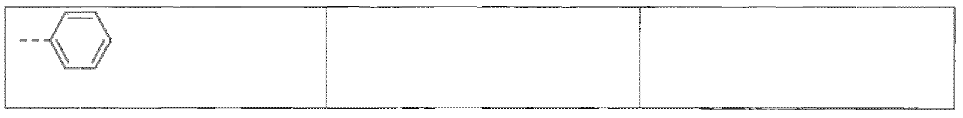

According to one embodiment of the present invention, the compound of formula (1) in the organic semiconductor layer is represented by one of the formulas A1 to A14

| | | |
|---|---|---|
| 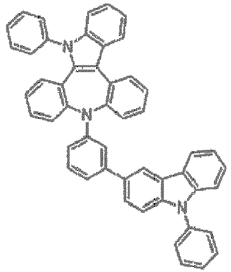 | 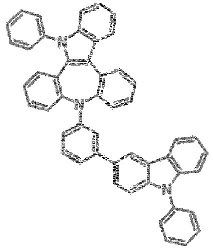 | 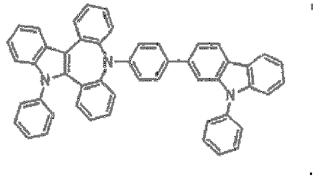 |
| A1 | A2 | A3 |
| 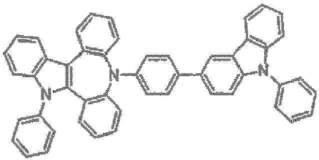 | 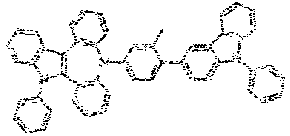 | 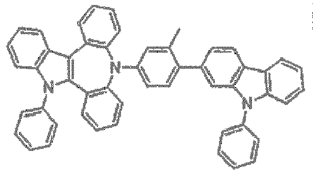 |
| A4 | A5 | A6 |
| 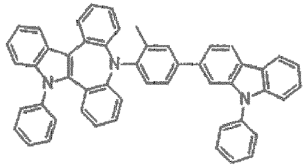 | 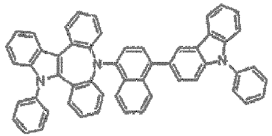 | 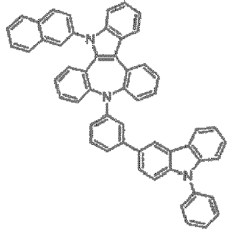 |
| A7 | AS | A9 |
| 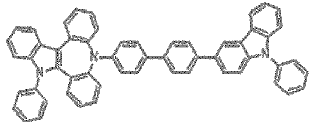 | 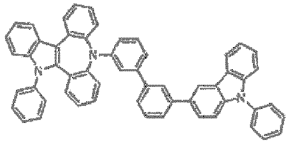 | 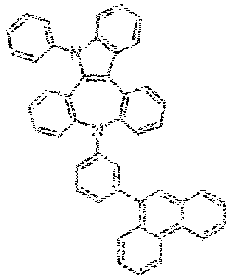 |
| A10 | A11 | A12 |
| 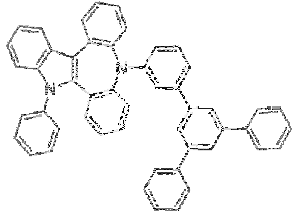 | 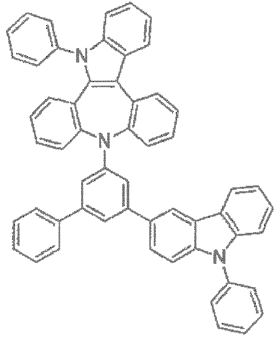 | |
| A13 | A14 | |

According to one embodiment of the present invention, the organic semiconductor layer is free of 14-([1,1':3',1"-terphenyl]-5'-yl)-9-(5'-phenyl-[1,1:3',1"-terphenyl]-3-yl)-9,14-dihydrodibenzo[2,3:6,7]azepino[4,5-b]indole or 14-([1,1':3',1"-terphenyl]-5'-yl)-9-(4-(triphenylen-2-yl)phenyl)-9,14-dihydrodibenzo[2,3:6,7]azepino[4,5-b]indole

### Hole injection layer

According to one embodiment of the present invention, the hole injection layer is free of copper phthalocyanine. Thereby, the hole injection layer can be deposited under conditions suitable for mass production.

According to one embodiment of the present invention, the hole injection layer is free of ionic liquids, metal phthalocyanine, copper phthalocyanine (CuPc), HAT-CN, Pyrazino[2,3-f][1,10]phenanthroline-2,3-dicarbonitrile, F4TCNQ, metal fluoride and/or metal oxides, wherein the metal in the metal oxide is selected from Re and/or Mo. Thereby, the hole injection layer can be deposited under conditions suitable for mass production.

Preferably, the organic p-dopant is an redox-dopant, i.e. capable of increasing the density of positive charge carriers in a hole transport material or hole transport layer, when added to a semiconductor.

According to one embodiment of the present invention, the hole injection material maybe non-emissive. In the context of the present specification the term "essentially non-emissive" or "non-emissive" means that the contribution of the hole injection material to the visible emission spectrum from an organic electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

According to one embodiment of the present invention, the hole injection material comprises a compound of formula (3) and/or a compound of formula (4)

M^{n⊕} (L^{⊖})ₙ (3)

wherein in formula (3)
- M is a metal ion;
- n is the valency of M, and n is an integer from 1 to 4; and
- L is a ligand comprising at least two carbon atoms; 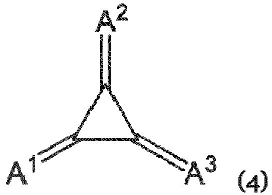 wherein in formula (4)
- A¹, A² and A³ are independently selected from a group (4a) 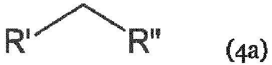
- each R' is independently selected from substituted or unsubstituted C₆ to C₃₆ aryl and substituted or unsubstituted C₂ to C₃₆ heteroaryl;
- if R' is substituted, the one or more substituents are independently selected from an electron-withdrawing group, preferably from F, CN, NO₂, perfluorinated alkyl, most preferred CF₃; and
- each R" is independently selected from an electron-withdrawing group, preferably from CN, or perfluorinated alkyl, preferably from CF₃, NO₂, or F.

### Formula (3)

The metal complex according to formula (3) may be non-emissive. In the context of the present specification the term "essentially non-emissive" or "non-emissive" means that the contribution of the metal complex according to formula (3) to the visible emission spectrum from an organic electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

According to one embodiment the metal ion M of formula (3) may be selected from a metal ion wherein the corresponding metal has an electronegativity value according to Allen of less than 2.4, preferably M may be selected from an alkali, alkaline earth, rare earth or transition metal, further preferred M may be selected from a metal with an atomic mass ≥ 24 Da, in addition preferred M may be selected from a metal with an atomic mass ≥ 24 Da and M has an oxidation number ≥ 2.

The term "electronegativity value according to Allen" especially refers to Allen, Leland C. (1989). "Electronegativity is the average one-electron energy of the valence-shell electrons in ground-state free atoms". Journal of the American Chemical Society 111 (25): 9003-9014.

According to one embodiment of the present invention, the valency n of M is 1 or 2.

According to one embodiment of the present invention, M is selected from a metal ion wherein the corresponding metal has an electronegativity value according to Allen of less than 2.4, preferably less than 2, more preferred less than 1.9, and the valency n of M is 1 or 2.

According to one embodiment of the present invention, M is selected from an alkali, alkaline earth, rare earth or transition metal, alternatively M is selected from alkali, alkaline earth, transition or a period 4 or 5 main group metal.

According to one embodiment of the present invention, in formula (3) M is selected from Li, Na, K, Cs, Mg, Mn, Cu, Fe, Zn, Ag, Bi, or Mo.

According to one embodiment of the present invention, in formula (3) M is selected from Na, K, Cs, Mg, Mn, Cu, Zn and Ag.

According to one embodiment of the present invention, in formula (3) M is selected from Na, K, Mg, Mn, Cu, Fe, Zn and Ag.

According to one embodiment of the present invention, in formula (3) M is selected from Na, K, Mg, Mn, Cu, Fe, Zn and Ag, wherein if M is Cu, n is 2, wherein if M is Fe, n is 2 and/or 3.

According to one embodiment of the present invention, M is not Li.

According to one embodiment of the present invention, M is not Li or K.

According to one embodiment of the present invention, M is not Mo.

According to one embodiment of the present invention, M is not Ir and/or Pt.

According to another embodiment the metal complex according to formula (3) may have a molecular weight Mw of ≥ 287 and ≤ 2000 g/mol, preferably a molecular weight Mw of ≥ 400 and ≤ 1500 g/mol, further preferred a molecular weight Mw of ≥ 580 and ≤ 1500 g/mol, in addition preferred a molecular weight Mw of ≥ 580 and ≤ 1400 g/mol.

According to another embodiment the metal complex according to formula (3) may have a molecular weight Mw of ≥ 400 g/mol and ≤ 2000 g/mol, preferably a molecular weight Mw of ≥ 400 g/mol and ≤ 1500 g/mol, further preferred a molecular weight Mw of ≥ 580 g/mol and ≤ 1500 g/mol, in addition preferred a molecular weight Mw of ≥ 580 g/mol and ≤ 1400 g/mol.

According to another embodiment the ligand L of formula (3), also named L, may be selected from a group comprising:
- at least three carbon atoms, alternatively at least four carbon atoms, and/or
- at least two oxygen atoms or one oxygen and one nitrogen atom, two to four oxygen atoms, two to four oxygen atoms and zero to two nitrogen atoms, and/or
- at least one or more groups selected from halogen, F, CN, substituted or unsubstituted C₁ to C₆ alkyl, substituted or unsubstituted C₁ to C₆ alkoxy, alternatively two or more groups selected from halogen, F, CN, substituted or unsubstituted C₁ to C₆ alkyl, substituted or unsubstituted C₁ to C₆ alkoxy, at least one or more groups selected from halogen, F, CN, substituted C₁ to C₆ alkyl, substituted C₁ to C₆ alkoxy, alternatively two or more groups selected from halogen, F, CN, perfluorinated C₁ to C₆ alkyl, perfluorinated C₁ to C₆ alkoxy, one or more groups selected from substituted or unsubstituted C₁ to C₆ alkyl, substituted or unsubstituted C₆ to C₁₂ aryl, and/or substituted or unsubstituted C₃ to C₁₂ heteroaryl,
   wherein the substituents are selected from D, C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR⁶, COOR⁶, halogen, F or CN;
   wherein R⁶ may be selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy.

According to another embodiment the ligand L of formula (3) may be selected from a group comprising at least two carbon atoms, alternatively at least three carbon atoms, at least one oxygen atom, at least two oxygen atoms, at least one oxygen and/or nitrogen atom, one nitrogen atom and at least two oxygen atoms, at least two carbon atoms and at least one oxygen atom, at least two carbon atoms and two oxygen atoms or one oxygen and one nitrogen atom, at least one or more groups selected from halogen, F, CN, substituted or unsubstituted C₁ to C₆ alkyl, substituted or unsubstituted C₁ to C₆ alkoxy, alternatively two or more groups selected from halogen, F, CN, substituted or unsubstituted C₁ to C₆ alkyl, substituted or unsubstituted C₁ to C₆ alkoxy, at least one or more groups selected from halogen, F, CN, substituted C₁ to C₆ alkyl, substituted C₁ to C₆ alkoxy, alternatively two or more groups selected from halogen, F, CN, perfluorinated C₁ to C₆ alkyl, perfluorinated C₁ to C₆ alkoxy, one or more groups selected from substituted or unsubstituted C₁ to C₆ alkyl, substituted or unsubstituted C₆ to C₁₂ aryl, and/or substituted or unsubstituted C₃ to C₁₂ heteroaryl,
wherein the substituents are selected from D, C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR⁶, COOR⁶, halogen, F or CN;
wherein R⁶ may be selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy.

According to another embodiment, the ligand L of formula (3) may be selected from a group comprising F, CN, perfluorinated C₁ to C₆ alkyl, substituted or unsubstituted C₁ to C₆ alkyl, substituted or unsubstituted C₁ to C₆ alkoxy.

The substituents may be selected from D, C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR⁶, COOR⁶, halogen, F or CN,
wherein R⁶ may be selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy.

According to another embodiment, the ligand L is free of sulfur atoms.

According to another embodiment, the ligand L is free of sulfur atoms or phthalocyanine groups.

According to another embodiment in formula (3) L is independently selected from a compound of the formula (10) 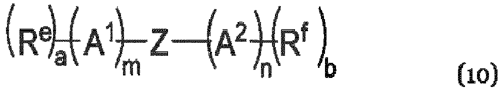 wherein
- m, and n are independently selected from o, 1;
- m+n≥1;
- a, and b are independently selected from o, 1;
- a+b≥1;
- Z is selected from CR^{g}, N, or O;
- if Z is O then a is o when m is o orb is o when n is o;
- R^{g} is selected from H, D, CN, substituted or unsubstituted aryl, substituted or unsubstituted heteroaryl, substituted or unsubstituted alkyl, substituted or unsubstituted carbocyclyl, or substituted or unsubstituted heterocyclyl;
- A¹ and A² are independently selected from C=O, C-O, or SO₂;
- A¹ and A² together can form a cycle with Z;
- R^{e} and R^{f} are independently selected from substituted or unsubstituted aryl, substituted or unsubstituted heteroaryl, substituted or unsubstituted alkyl, substituted or unsubstituted carbocyclyl, or substituted or unsubstituted heterocyclyl; and
- L is monoanionic. In this regard, the term monoanionic refers to an anion having a negative charge of -1.

According to one embodiment of formula (10), m and n are 1.

According to one embodiment of formula (10), R^{g} is selected from H, D, CN, substituted or unsubstituted C₆ to C₂₄ aryl, substituted or unsubstituted C₂ to C₂₄ heteroaryl, substituted or unsubstituted C₁ to C₂₄ alkyl, substituted or unsubstituted C₃ to C₂₄ carbocyclyl, or substituted or unsubstituted C₂ to C₂₄ heterocyclyl; wherein
aryl may by C₆ to C₂₄ aryl, C₆ to C₂₂ aryl, C₆ to C₂₀ aryl, C₆ to C₁₈ aryl, C₆ to C₁₆ aryl, C₆ to C₁₄ aryl, C₆ to C₁₂ aryl, C₆ to C₁₀ aryl, or C₆ aryl;
heteroaryl may be C₂ to C₂₄ heteroaryl, C₂ to C₂₂ heteroaryl, C₂ to C₂₀ heteroaryl, C₂ to C₁₈ heteroaryl, C₂ to C₁₆ heteroaryl, C₂ to C₁₄ heteroaryl, C₂ to C₁₂ heteroaryl, C₂ to C₁₀ heteroaryl, C₂ to C₉ heteroaryl, C₂ to C₈ heteroaryl, C₂ to C₇ heteroaryl, C₂ to C₅ heteroaryl, C₂ to C₄ heteroaryl, or C₂ to C₃ heteroaryl;
alkyl may be C₁ to C₂₄ alkyl, C₁ to C₂₀ alkyl, C₁ to C₁₆ alkyl, C₁ to C₁₂ alkyl, C₁ to C₁₀ alkyl, C₁ to C₈ alkyl, C₁ to C₆ alkyl, C₁ to C₄ alkyl, C₁ to C₃ alkyl, or C₁ to C₂ alkyl;
carbocyclyl may be C₃ to C₂₄ carbocyclyl, C₃ to C₂₂ carbocyclyl, C₃ to C₁₈ carbocyclyl, C₃ to C₁₆ carbocyclyl, C₃ to C₁₄ carbocyclyl, C₃ to C₁₂ carbocyclyl, C₃ to C₁₀ carbocyclyl, C₃ to C₆ carbocyclyl, or C₆ carbocyclyl; and
heterocyclyl may be C₂ to C₂₄ heterocyclyl, C₂ to C₂₂ heterocyclyl, C₂ to C₂₀ heterocyclyl, C₂ to C₁₈ heterocyclyl, C₂ to C₁₆ heterocyclyl, C₂ to C₁₄ heterocyclyl, C₂ to C₁₂ heterocyclyl, C₂ to C₁₀ heterocyclyl, or C₂ to C₆ heterocyclyl.

According to one embodiment of formula (10), R^{g} is selected from H, D, substituted or unsubstituted aryl, substituted or unsubstituted heteroaryl, substituted or unsubstituted alkyl, wherein
aryl may by C₆ to C₂₄ aryl, C₆ to C₂₂ aryl, C₆ to C₂₀ aryl, C₆ to C₁₈ aryl, C₆ to C₁₆ aryl, C₆ to C₁₄ aryl, C₆ to C₁₂ aryl, C₆ to C₁₀ aryl, or C₆ aryl;
heteroaryl may be C₂ to C₂₄ heteroaryl, C₂ to C₂₂ heteroaryl, C₂ to C₂₀ heteroaryl, C₂ to C₁₈ heteroaryl, C₂ to C₁₆ heteroaryl, C₂ to C₁₄ heteroaryl, C₂ to C₁₂ heteroaryl, C₂ to C₁₀ heteroaryl, C₂ to C₉ heteroaryl, C₂ to C₈ heteroaryl, C₂ to C₇ heteroaryl, C₂ to C₅ heteroaryl, C₂ to C₄ heteroaryl, or C₂ to C₃ heteroaryl; and
alkyl may be C₁ to C₂₄ alkyl, C₁ to C₂₀ alkyl, C₁ to C₁₆ alkyl, C₁ to C₁₂ alkyl, C₁ to C₁₀ alkyl, C₁ to C₈ alkyl, C₁ to C₆ alkyl, C₁ to C₄ alkyl, C₁ to C₃ alkyl, or C₁ to C₂ alkyl.

According to one embodiment of formula (10), R^{g} is selected from H, D, CN, substituted or unsubstituted C₆ to C₂₄ aryl, substituted or unsubstituted C₂ to C₂₄ heteroaryl, substituted or unsubstituted C₁ to C₂₄ alkyl.

In case that R^{g} is substituted the one or more substituents are independently selected from C₆ to C₂₄ aryl, substituted C₂ to C₂₄ heteroaryl, substituted C₁ to C₂₄ alkyl, substituted C₃ to C₂₄ carbocyclyl, or substituted C₂ to C₂₄ heterocyclyl, the one or more substituents may be independently selected from F, Cl, CN, perfluorinated C₁ to C₈ alkyl, perfluorinated C₆ to C₁₂ aryl, or C₂ to C₁₂ heteroaryl.

According to one embodiment of formula (10), R^{e} and R^{f} are independently selected from substituted or unsubstituted aryl, substituted or unsubstituted heteroaryl, substituted or unsubstituted alkyl, wherein
aryl may by C₆ to C₂₄ aryl, C₆ to C₂₂ aryl, C₆ to C₂₀ aryl, C₆ to C₁₈ aryl, C₆ to C₁₆ aryl, C₆ to C₁₄ aryl, C₆ to C₁₂ aryl, C₆ to C₁₀ aryl, or C₆ aryl;
heteroaryl may be C₂ to C₂₄ heteroaryl, C₂ to C₂₂ heteroaryl, C₂ to C₂₀ heteroaryl, C₂ to C₁₈ heteroaryl, C₂ to C₁₆ heteroaryl, C₂ to C₁₄ heteroaryl, C₂ to C₁₂ heteroaryl, C₂ to C₁₀ heteroaryl, C₂ to C₉ heteroaryl, C₂ to C₈ heteroaryl, C₂ to C₇ heteroaryl, C₂ to C₅ heteroaryl, C₂ to C₄ heteroaryl, or C₂ to C₃ heteroaryl; and
alkyl may be C₁ to C₂₄ alkyl, C₁ to C₂₀ alkyl, C₁ to C₁₆ alkyl, C₁ to C₁₂ alkyl, C₁ to C₁₀ alkyl, C₁ to C₈ alkyl, C₁ to C₆ alkyl, C₁ to C₄ alkyl, C₁ to C₃ alkyl, or C₁ to C₂ alkyl.

According to one embodiment of formula (10), R^{e} and R^{f} are independently selected from substituted or unsubstituted C₆ to C₂₄ aryl, substituted or unsubstituted C₂ to C₂₄ heteroaryl, substituted or unsubstituted C₁ to C₂₄ alkyl, substituted or unsubstituted C₃ to C₂₄ carbocyclyl, or substituted or unsubstituted C₂ to C₂₄ heterocyclyl; wherein
aryl may by C₆ to C₂₄ aryl, C₆ to C₂₂ aryl, C₆ to C₂₀ aryl, C₆ to C₁₈ aryl, C₆ to C₁₆ aryl, C₆ to C₁₄ aryl, C₆ to C₁₂ aryl, C₆ to C₁₀ aryl, or C₆ aryl;
heteroaryl may be C₂ to C₂₄ heteroaryl, C₂ to C₂₂ heteroaryl, C₂ to C₂₀ heteroaryl, C₂ to C₁₈ heteroaryl, C₂ to C₁₆ heteroaryl, C₂ to C₁₄ heteroaryl, C₂ to C₁₂ heteroaryl, C₂ to C₁₀ heteroaryl, C₂ to C₉ heteroaryl, C₂ to C₈ heteroaryl, C₂ to C₇ heteroaryl, C₂ to C₅ heteroaryl, C₂ to C₄ heteroaryl, or C₂ to C₃ heteroaryl;
alkyl may be C₁ to C₂₄ alkyl, C₁ to C₂₀ alkyl, C₁ to C₁₆ alkyl, C₁ to C₁₂ alkyl, C₁ to C₁₀ alkyl, C₁ to C₈ alkyl, C₁ to C₆ alkyl, C₁ to C₄ alkyl, C₁ to C₃ alkyl, or C₁ to C₂ alkyl;
carbocyclyl may be C₃ to C₂₄ carbocyclyl, C₃ to C₂₂ carbocyclyl, C₃ to C₁₈ carbocyclyl, C₃ to C₁₆ carbocyclyl, C₃ to C₁₄ carbocyclyl, C₃ to C₁₂ carbocyclyl, C₃ to C₁₀ carbocyclyl, C₃ to C₆ carbocyclyl, or C₆ carbocyclyl; and
heterocyclyl may be C₂ to C₂₄ heterocyclyl, C₂ to C₂₂ heterocyclyl, C₂ to C₂₀ heterocyclyl, C₂ to C₁₈ heterocyclyl, C₂ to C₁₆ heterocyclyl, C₂ to C₁₄ heterocyclyl, C₂ to C₁₂ heterocyclyl, C₂ to C₁₀ heterocyclyl, or C₂ to C₆ heterocyclyl.

According to one embodiment of formula (10), R^{e} and R^{f} are independently selected from substituted or unsubstituted C₆ to C₂₄ aryl, substituted or unsubstituted C₂ to C₂₄ heteroaryl, substituted or unsubstituted C₁ to C₂₄ alkyl.

In case that R^{e} and R^{f} are substituted the one or more substituents are independently selected from from F, Cl, CN, perfluorinated C₁ to C₈ alkyl, perfluorinated C₆ to C₁₂ aryl, or C₂ to C₁₂ heteroaryl.

According to another embodiment, the ligand L of formula (3) may be independently selected from G1 to G65, wherein G1 to G62 are preferred:

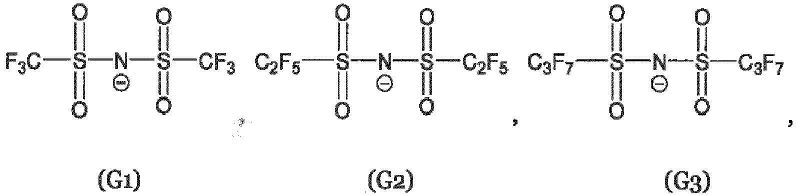

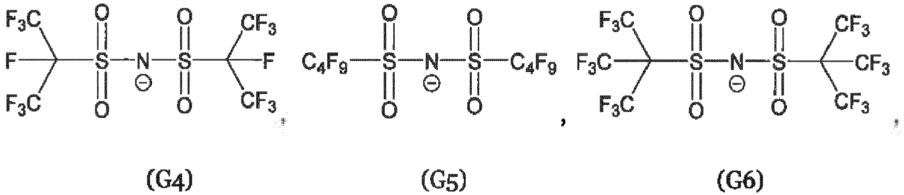

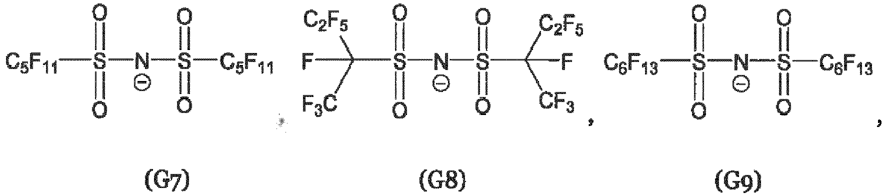

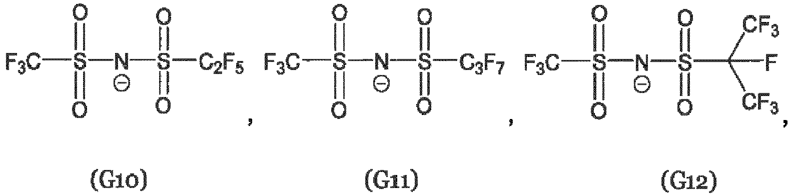

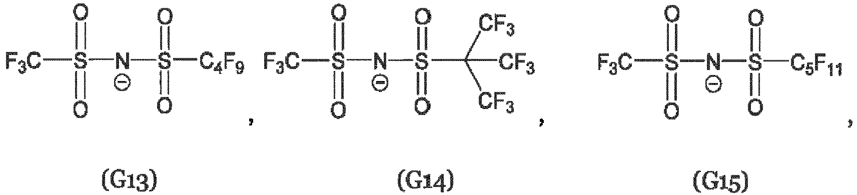

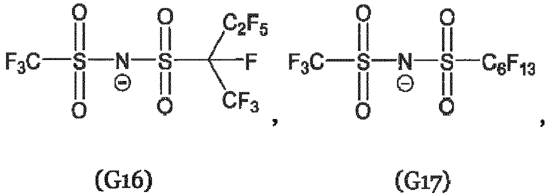

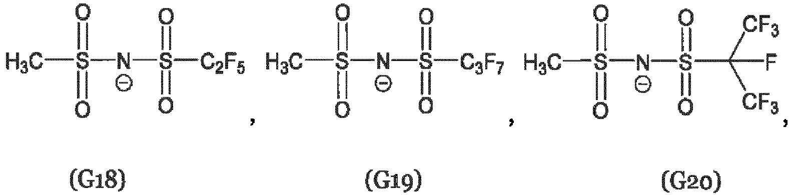

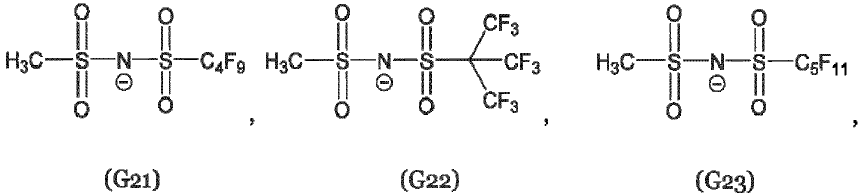

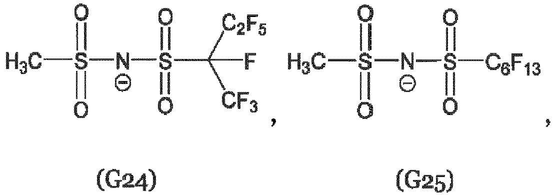

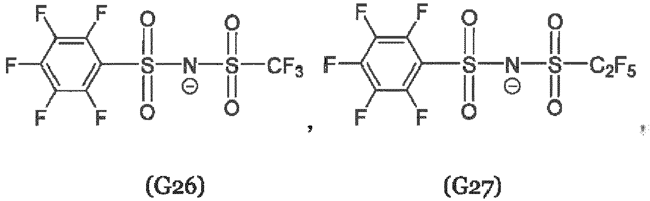

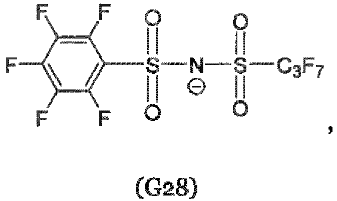

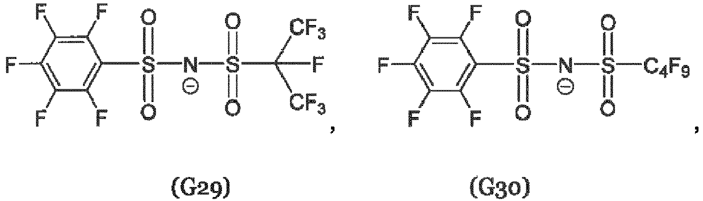

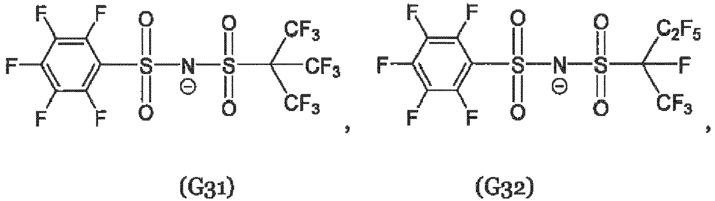

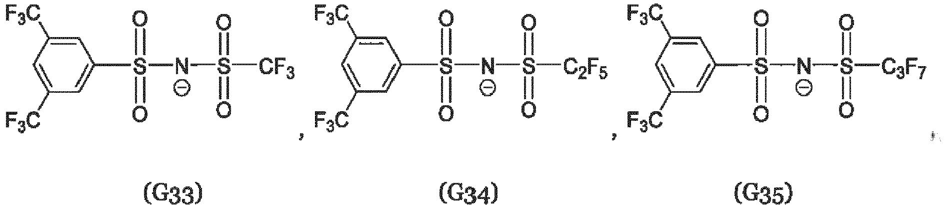

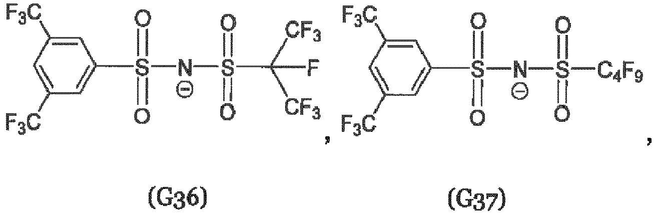

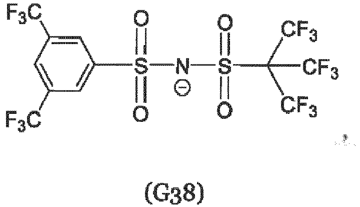

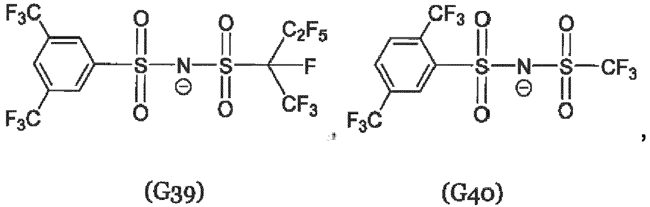

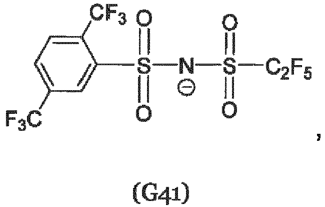

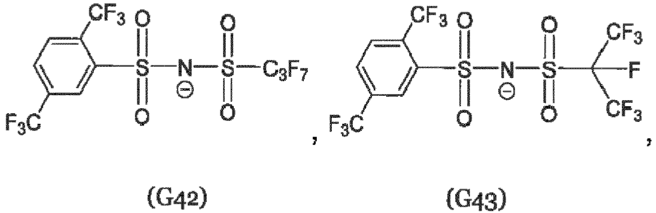

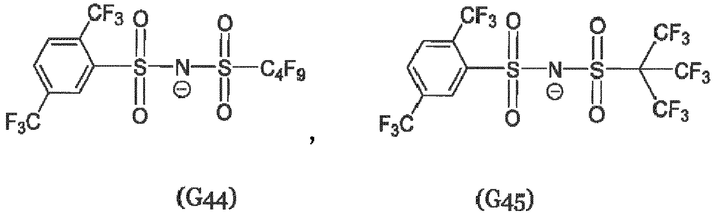

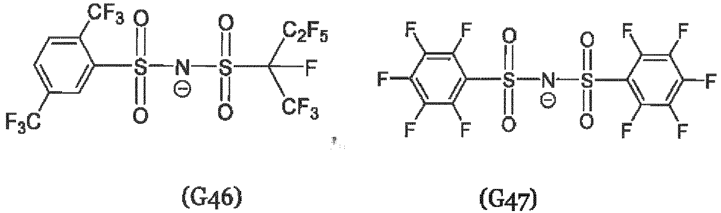

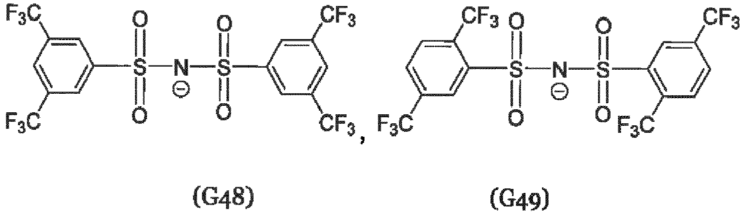

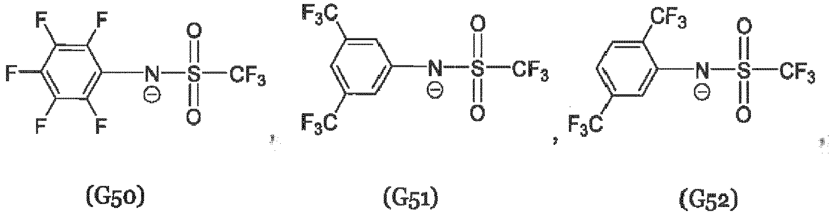

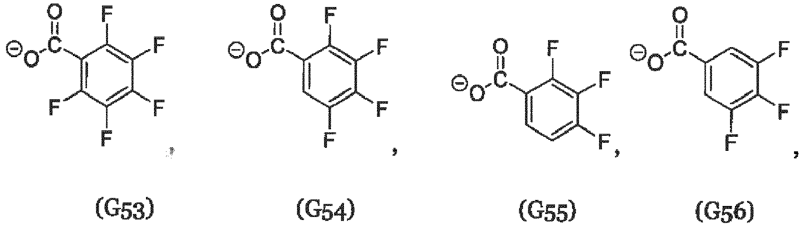

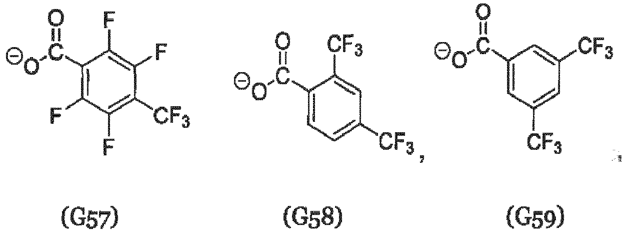

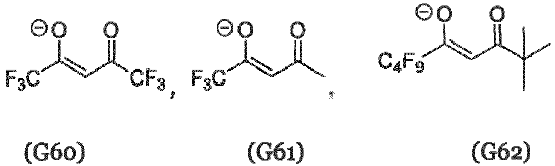

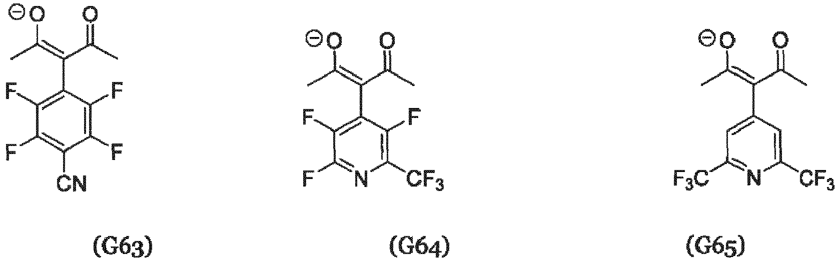

Preferably, L is selected from (G2) to (G59), alternatively L is selected from (G2) to (G52).

According to another embodiment, L is selected from (G1) to (G52) and (G60) to (G64).

According to another embodiment, L is selected from (G1) to (G52) and (G60) to (G62).

The negative charge in metal complexes of formula (3) may be delocalised partially or fully over the ligand L.

### Metal complex of formulas (3a) to (3e)

According to one embodiment, the metal complex (3) may be selected from the following formulas (3a) to (3e), wherein formulas (3a) to (3d) are preferred: 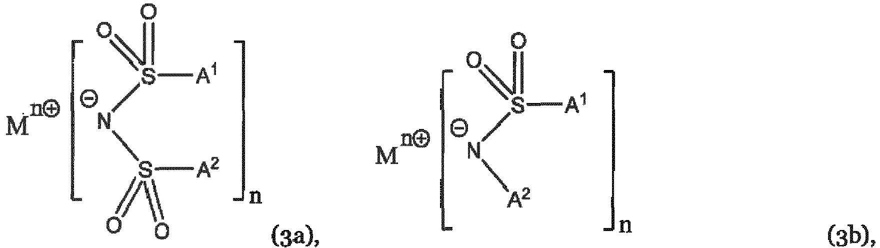 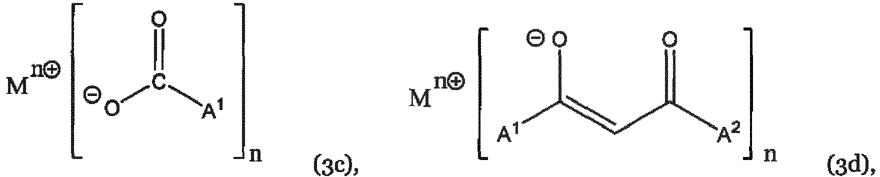 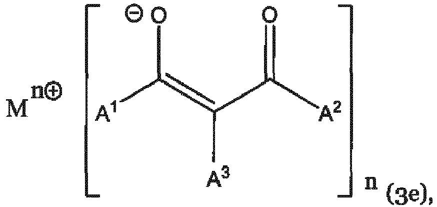 wherein
- M: is a metal ion;
- n: is the valency of M;
- A¹ and A²: in formulas (3a) to (3e) may be independently selected from substituted or unsubstituted C₁ to C₁₂ alkyl, substituted or unsubstituted C₆ to C₁₂ aryl, substituted or unsubstituted C₃ to C₁₂ heteroaryl;
- A³: in formula (3e) is selected from H, D, substituted or unsubstituted C₁ to C₁₂ alkyl, substituted or unsubstituted C₆ to C₁₂ aryl, substituted or unsubstituted C₃ to C₁₂ heteroaryl;
wherein
in formulas (3a) to (3e) the substituents of A¹ and A² and/or A3 may be independently selected from D, C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR¹, COOR¹, halogen, F or CN, wherein
R¹ may be selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy.

The negative charge in metal complexes of formula (3a), (3b), (3c) and/or (3d) may be delocalized partially or fully over the carbon and hetero atoms and A¹ and/or A² and/or A³.

According to one embodiment in formulas (3a) to (3e) at least one of A¹ and A² and/or A3 may comprise a substituent, wherein at least one of the substituents of A¹ and A2 and/or A3 may be independently selected from C₃ to C₉ heteroaryl, C₁ to C₆ alkoxy, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN; preferably at least one of A¹ and A² and/or A³ comprises at least two substituents, wherein
the substituents on A¹ and A² and/or A3 may be independently selected from C₃ to C₉ heteroaryl, C₁ to C₆ alkoxy, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkoxy, COR¹, COOR¹, halogen, F or CN; and further preferred A¹ and A2 and/or A³ may comprise at least one substituent independently selected from halogen, F, CF₃, C₂F₅, C₃F₇, C₄F₉, OCF₃, OC₂F₅, or CN; and in addition preferred A¹ and A² may comprise at least two substituents independently selected from halogen, F, CF₃, C₂F₅, C₃F₇, C₄F₉, OCF₃, OC₂F₅ or CN.

According to one embodiment of the present invention, in formulas (3a) to (3e) A¹ and A² and/or A³ may be independently selected from CF₃, C₂F₅, C₃F₇, C₄F₉, C₅F₁₁, C₆F₁₃ and/or phenyl substituted with two to five groups independently selected from F or CF₃, alternatively C₂F₅, C₃F₇, C₄F₉, C₅F₁₁, C₆F₁₃ and/or phenyl substituted with two to five groups independently selected from F or CF₃, alternatively CF₃, C₂F₅, C₃F₇, C₄F₉, C₅F₁₁, C₆F₁₃ or phenyl substituted with zero to two CF₃ groups and/or zero to five F atoms.

According to one embodiment of the present invention, the metal complex may be selected from
- Formula (3a), wherein M is selected from an alkali, alkaline earth, transition or rare earth metal; and/or
- Formula (3b), wherein M is selected from alkali, alkaline earth, transition or rare earth metal; and/or
- Formula (3c), wherein M is selected from alkali, alkaline earth or main group metal. According to one embodiment of the present invention, the metal complex may be selected from
- Formula (3a), wherein M is selected from an alkali, alkaline earth, transition or rare earth metal; and/or
- Formula (3b), wherein M is selected from alkali, alkaline earth, transition or rare earth metal; and/or
- Formula (3d), wherein M is selected from alkali, alkaline earth, transition or rare earth metal;
and/or
- Formula (3e), wherein M is selected from alkali, alkaline earth, transition or rare earth metal.

According to one embodiment of the present invention, the metal complex may be selected from Formula (3a) or (3b),
wherein M is selected from a metal ion wherein the corresponding metal has an electronegativity value according to Allen of less than 2.4, preferably M is selected from an alkali, alkaline earth, rare earth or transition metal, further preferred M is selected from a metal with an atomic mass ≥ 24 Da, in addition preferred M is selected from a metal with an atomic mass ≥ 24 Da and M has an oxidation number ≥ 2; and/or Formula(IIc), wherein M is selected from Bi.

Metal complexes of the following formulas may be particularly preferred:
Li TFSI
K TFSI
Cs TFSI
Ag TFSI
Mg(TFSI)2
Mn(TFSI)₂
Sc(TFSI)₃
Mg[N(SO₂ⁱC₃F₇)₂]₂
Zn[N(SO₂ⁱC₃F₇)₂]₂
Ag[N(SO₂ⁱC₃F₇)₂]
Ag[N(SO₂C₃F₇)₂]
Ag[N(SO₂C₄F₉)₂]
Ag[N(SO₂CF₃)(SO₂C₄F₉)]
Cu[N(SO₂ⁱC₃F₇)₂]₂
Cu[N(SO₂C₃F₇)₂]₂
Cu[N(SO₂CF₃)(SO₂C₄F₉)]₂
Mg[N(SO₂CF₃)(SO₂C₄F₉)]₂
Mn[N(SO₂CF₃)(SO₂C₄F₉)]₂
Cu[N(SO₂CH₃)(SO₂C₄F₉)]₂
Ag[N(SO₂CH₃)(SO₂C₄F₉)]

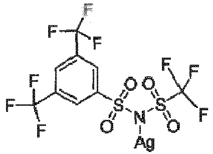

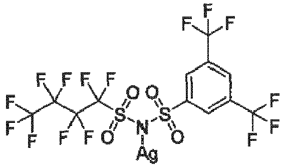

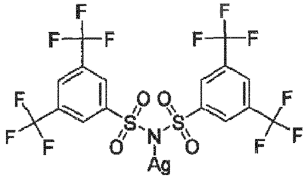

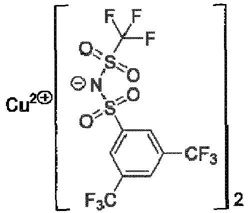

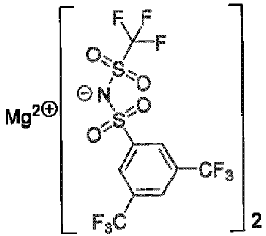

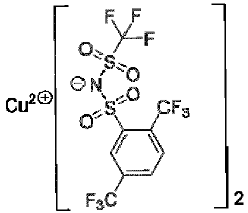

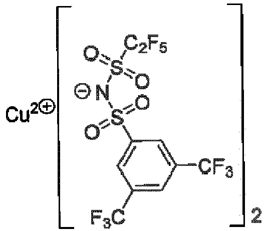

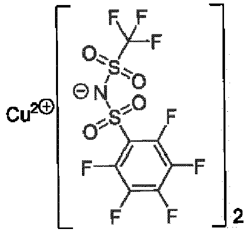

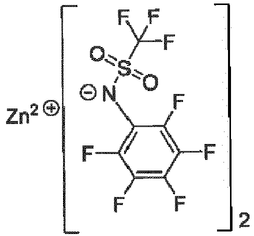

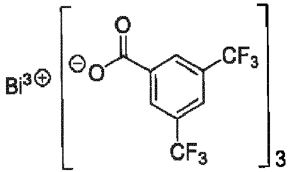

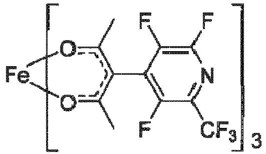

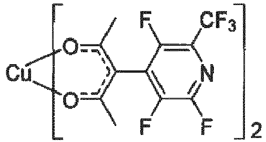

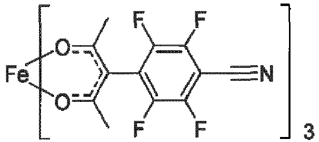

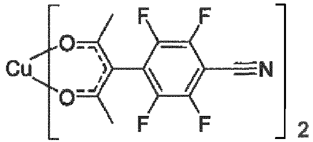

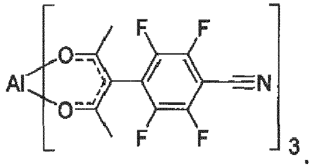

According to one embodiment, the metal complex may be free of bis(trifluoromethane)-sulfonimide (TFSI). Thereby, the metal complex may be particularly suited to mass production of organic electronic devices.

### Formula (4)

According to one embodiment, the compound of formula (4) has the formula (4') 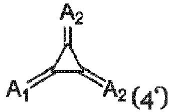 wherein
- A¹ and A² are independently selected from a group (4a) 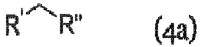
- each R' is being independently selected from substituted or unsubstituted C₆ to C₃₆ aryl and substituted or unsubstituted C₂ to C₃₆ heteroaryl;
- if R' is substituted, the one or more substituents are independently selected from an electron-withdrawing group, preferably from F, CN, perfluorinated alkyl, most preferred CF₃; and
- each R' is independently selected from an electron-withdrawing group, preferably from CN, or perfluorinated alkyl, preferably from CF₃, NO₂, or F.

### Matrix material of the HIL

According to one embodiment of the present invention, the matrix material of the hole injection layer comprises a substantially covalent matrix compound. According to one embodiment the substantially covalent matrix compound may be selected from at least one organic compound. The substantially covalent matrix may consists substantially from covalently bound C, H, O, N, S, which optionally comprise in addition covalently bound B, P, As and/or Se.

According to one embodiment of the organic electronic device, the organic semiconductor layer further comprises a substantially covalent matrix compound, wherein the substantially covalent matrix compound may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as substantially covalent matrix compounds of the hole injection layer.

In one embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the substantially covalent matrix compound comprises at least one arylamine moiety, alternatively a diarylamine moiety, alternatively a triarylamine moiety.

Preferably, the substantially covalent matrix compound is free of metals and/or ionic bonds.

According to one embodiment of the present invention, the matrix material of the hole injection layer comprises a compound of formula (6), a compound of formula (7); a compound a compound of formula (8), a compound of formula (11), or mixtures thereof; 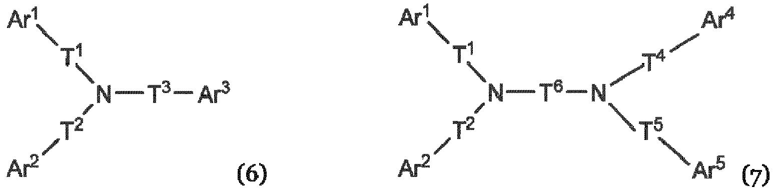 wherein in formulas (6) and (7)
- ¹, T², T³, T⁴ and T⁵ are independently selected from a single bond, phenylene, biphenylene, terphenylene or naphthenylene, preferably a single bond or phenylene;
- ⁶ is phenylene, biphenylene, terphenylene or naphthenylene;
- Ar¹, Ar², Ar³, Ar⁴ and Ar³ are independently selected from substituted or unsubstituted C₆ to C₂₀ aryl, or substituted or unsubstituted C₃ to C₂₀ heteroarylene, preferably from substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are independently selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
- If one or more of Ar¹, Ar², Ar³, Ar⁴ and Ar⁵ is/are substituted, the one ore more substituents is/are independently selected from H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are independently selected from the group comprising unsaturated 5- to 7-member ring of a heterocycle, 5-to 6-member of an aromatic heterocycle, unsaturated 5- to 7-member ring of a non-heterocycle, and 6-member ring of an aromatic non-heterocycle, wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl; 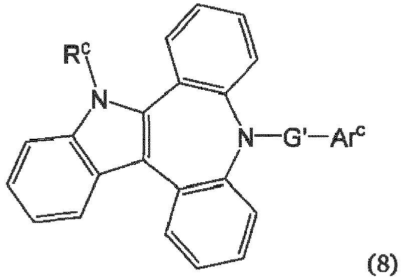 wherein in formula (8)
- R^{c} is selected from substituted or unsubstituted aryl, substituted or unsubstituted heteroaryl, substituted or unsubstituted alkyl; wherein
   aryl may by C₆ to C₂₄ aryl, C₆ to C₂₂ aryl, C₆ to C₂₀ aryl, C₆ to C₁₈ aryl, C₆ to C₁₆ aryl, C₆ to C₁₄ aryl, C₆ to C₁₂ aryl, C₆ to C₁₀ aryl, or C₆ aryl;
   heteroaryl may be C₂ to C₂₄ heteroaryl, C₂ to C₂₂ heteroaryl, C₂ to C₂₆ heteroaryl, C₂ to C₁₈ heteroaryl, C₂ to C₁₆ heteroaryl, C₂ to C₁₄ heteroaryl, C₂ to C₁₂ heteroaryl, C₂ to C₁₀ heteroaryl, C₂ to C₉ heteroaryl, C₂ to C₈ heteroaryl, C₂ to C₇ heteroaryl, C₂ to C₅ heteroaryl, C₂ to C₄ heteroaryl, or C₂ to C₃ heteroaryl;
   alkyl may be C₁ to C₂₄ alkyl, C₁ to C₂₀ alkyl, C₁ to C₁₆ alkyl, C₁ to C₁₂ alkyl, C₁ to C₁₀ alkyl, C₁ to C₈ alkyl, C₁ to C₆ alkyl, C₁ to C₄ alkyl, C₁ to C₃ alkyl, or C₁ to C₂ alkyl;
- G' is selected from a substituted or unsubstituted C₆ to C₁₈ aryl and C₃ to C₁₈ heteroaryl; and
- Ar^{c} is selected from a substituted or unsubstituted C₆ to C₂₄ aryl comprising 0 to 3 fused rings; a or C₃ to C₂₄ heteroaryl comprising 0 to 3 fused rings; a group of formula (9a); or a group of formula (9b); 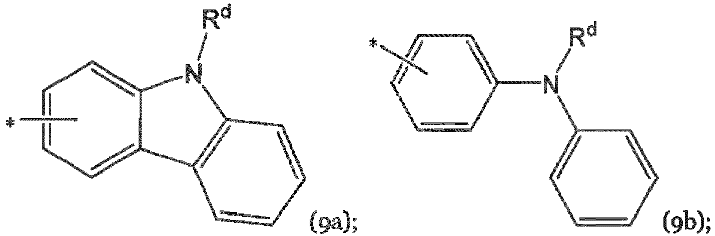
- R^{d} is selected from a substituted or unsubstituted C₆ to C₃₆ aryl; a substituted or unsubstituted C₂ to C₃₆ heteroaryl; or a substituted or unsubstituted C₁ to C₁₈ alkyl;

   (Ar¹')ₖ-(Ar²')ₛ-Ar³'-(Ar⁴')ₚ-(Ar⁵')_{q}-(Ar⁶')ᵣ (11),

   wherein in formula (11)
   - k, s, q, r: are independently selected from each other 0, 1 or 2,
   - p: is 1, 2 or 3,
   wherein 2 ≤ k+s+q+r+p ≤ 11,
   - Ar^{1'} to Ar^{6'}: are independently selected from a substituted or unsubstituted unsaturated 5-to 7-member ring of a heterocycle, a substituted or unsubstituted C₆ to C₃₀ aryl, a substituted or unsubstituted C₃ to C₃₀ heteroaryl, a substituted or unsubstituted fluorene, or a fused ring system comprising 2 to 6 substituted or unsubstituted 5- to 7-member rings and the rings are independently selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle; preferably independently selected from substituted or unsubstituted biphenylene, substituted or unsubstituted fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted or unsubstituted azepine, substituted or unsubstituted dibenzo[b,f]azepine, 9,9'-spirobi[fluorene], substituted or unsubstituted spiro[fluorene-9,9'-xanthene], substituted or unsubstituted 9,14-dihydrodibenzo[2,3:6,7]azepino[4,5-b]indole, or a substituted or unsubstituted aromatic fused ring system comprising at least three substituted or unsubstituted aromatic rings independently selected from the group comprising substituted or unsubstituted non-hetero, substituted or unsubstituted hetero 5-member rings, substituted or unsubstituted 6-member rings and/or substituted or unsubstituted 7-member rings,
   wherein the substituents are selected from the group H, D, C₁ to C₁₂ alkyl, unsubstituted C₆ to C₁₈ aryl, unsubstituted C₃ to C₁₈ heteroaryl, a fused ring system comprising 2 to 6 unsubstituted 5- to 7-member rings and the rings are independently selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

According to one embodiment of the present invention, the matrix material of the hole injection layer comprises a compound of formula (6), a compound of formula (7); a compound of formula (8), or mixtures thereof; 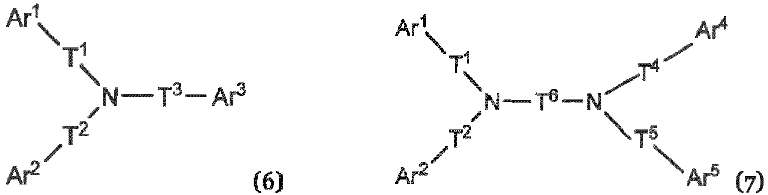 wherein in formulas (6) and (7)
- T¹, T², T³, T⁴ and T⁵ are independently selected from a single bond, phenylene, biphenylene, terphenylene or naphthenylene, preferably a single bond or phenylene;
- T⁶ is phenylene, biphenylene, terphenylene or naphthenylene;
- Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, preferably from substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are independently selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
- If one or more of Ar¹, Ar², Ar³, Ar⁴ and Ar⁵ is/are substituted, the one ore more substituents is/are independently selected from H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are independently selected from the group comprising unsaturated 5- to 7-member ring of a heterocycle, 5-to 6-member of an aromatic heterocycle, unsaturated 5- to 7-member ring of a non-heterocycle, and 6-member ring of an aromatic non-heterocycle, wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl; 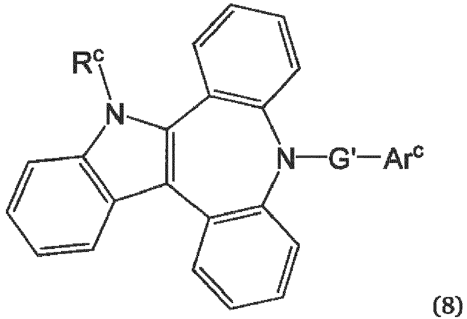 wherein in formula (8)
- R^{c} is selected from substituted or unsubstituted aryl, substituted or unsubstituted heteroaryl, substituted or unsubstituted alkyl; wherein
   aryl may by C₆ to C₂₄ aryl, C₆ to C₂₂ aryl, C₆ to C₂₀ aryl, C₆ to Cis aryl, C₆ to C₁₆ aryl, C₆ to C₁₄ aryl, C₆ to C₁₂ aryl, C₆ to C₁₀ aryl, or C₆ aryl;
   heteroaryl may be C₂ to C₂₄ heteroaryl, C₂ to C₂₂ heteroaryl, C₂ to C₂₀ heteroaryl, C₂ to C₁₈ heteroaryl, C₂ to C₁₆ heteroaryl, C₂ to C₁₄ heteroaryl, C₂ to C₁₂ heteroaryl, C₂ to C₁₀ heteroaryl, C₂ to C₉ heteroaryl, C₂ to C₈ heteroaryl, C₂ to C₇ heteroaryl, C₂ to C₅ heteroaryl, C₂ to C₄ heteroaryl, or C₂ to C₃ heteroaryl;
   alkyl may be C₁ to C₂₄ alkyl, C₁ to C₂₀ alkyl, C₁ to C₁₆ alkyl, C₁ to C₁₂ alkyl, C₁ to C₁₀ alkyl, C₁ to C₈ alkyl, C₁ to C₆ alkyl, C₁ to C₄ alkyl, C₁ to C₃ alkyl, or C₁ to C₂ alkyl;
- G' is selected from a substituted or unsubstituted C₆ to C₁₈ aryl and C₃ to C₁₈ heteroaryl; and
- Ar^{c} is selected from a substituted or unsubstituted C₆ to C₂₄ aryl comprising 0 to 3 fused rings; a or C₃ to C₂₄ heteroaryl comprising 0 to 3 fused rings; a group of formula (9a); or a group of formula (9b); 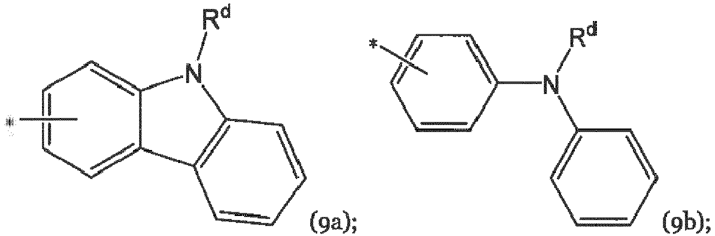
- R^{d} is selected from a substituted or unsubstituted C₆ to C₃₆ aryl; a substituted or unsubstituted C₂ to C₃₆ heteroaryl; or a substituted or unsubstituted C₁ to C₁₈ alkyl.

According to one embodiment of the present invention, R^{c} is selected from a C₆ to C₁₈ aryl, or C₁ to C₁₈ alkyl.

According to one embodiment of the present invention, G' is is selected from a substituted or unsubstituted C₆ to C₁₂ aryl, wherein the aryl may be a biaryl, such as biphenylene, or a condensed aryl, such as napthylene.

According to one embodiment of the present invention, G' is is selected from an unsubstituted C₆ to C₁₂ aryl, wherein the aryl may be a biaryl, such as biphenylene, or a condensed aryl, such as napthylene.

According to one embodiment of the present invention, Ar^{c} is selected from a substituted or unsubstituted C₁₃ to C₂₄ aryl comprising 0 to 3 fused rings or formula (9a) 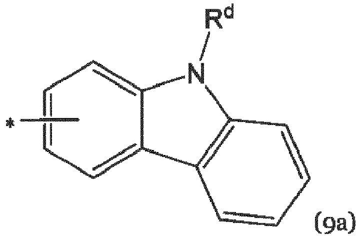 wherein R^{d} is selected from a substituted or unsubstituted C₆ to C₃₆ aryl; or a substituted or unsubstituted C₁ to C₁₈ alkyl.

Embodiments described herein with respect to the compound of formula (1) are also embodiments for the compound of formula 8, wherein R^{a} corresponds to R^{c}, Ar^{a} corresponds to Ar^{c} G corresponds to G', formula (2a) corresponds to formula (9a), formula (2b) corresponds to formula (9b), and R^{b} corresponds to R^{d}.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar¹, Ar², Ar³, Ar⁴ and Ar⁵ may be independently selected from D1 to D16: 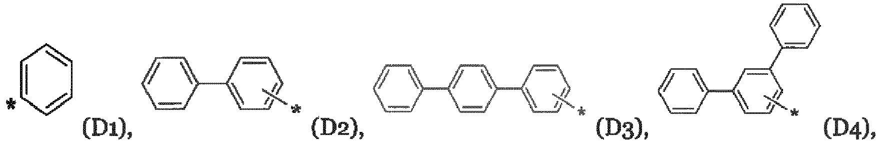 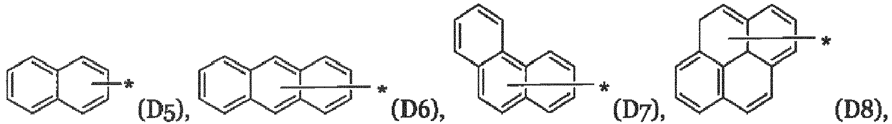 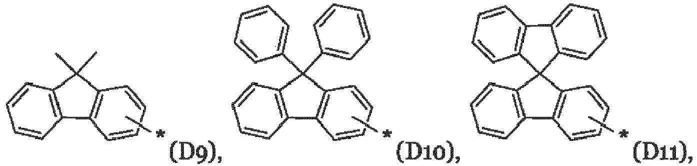 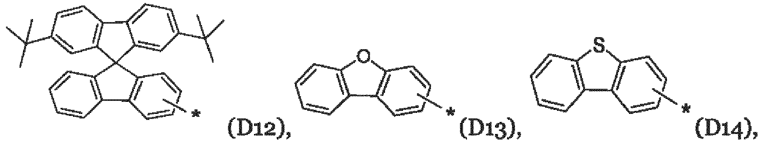 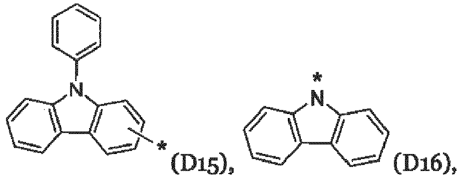 wherein the asterisk "*" denotes the binding position.

According to an embodiment, wherein Ar¹, Ar², Ar³, Ar⁴ and Ar⁵ may be independently selected from D1 to D15; alternatively selected from D1 to D10 and D13 to D15.

According to an embodiment, wherein Ar¹, Ar², Ar³, Ar⁴ and Ar⁵ may be independently selected from the group consisting of D1, D2, D5, D7, D9, D10, D13 to D16.

The rate onset temperature may be in a range particularly suited to mass production, when Ar¹, Ar², Ar³, Ar⁴ and Ar⁵ are selected in this range.

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the matrix compound of formula (6) or formula (7) are selected from F1 to F18:

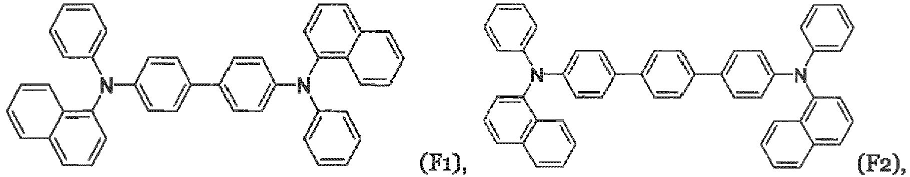

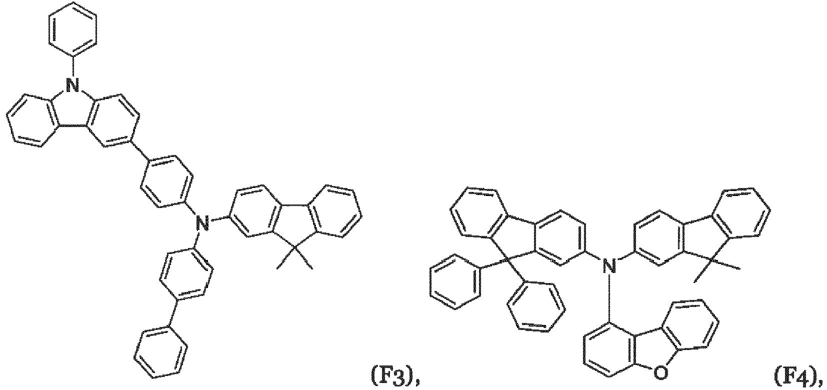

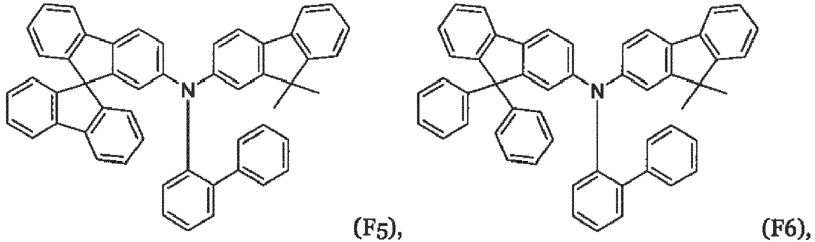

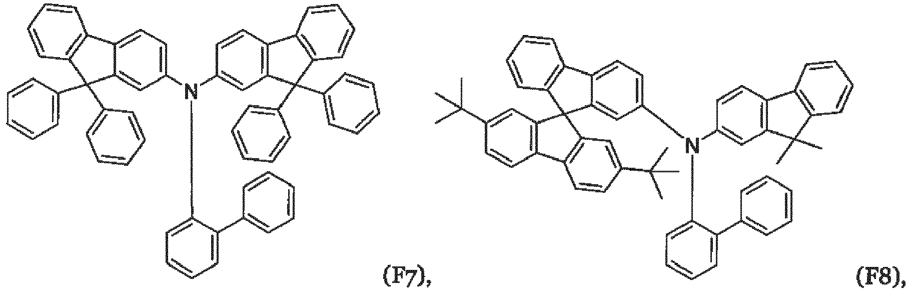

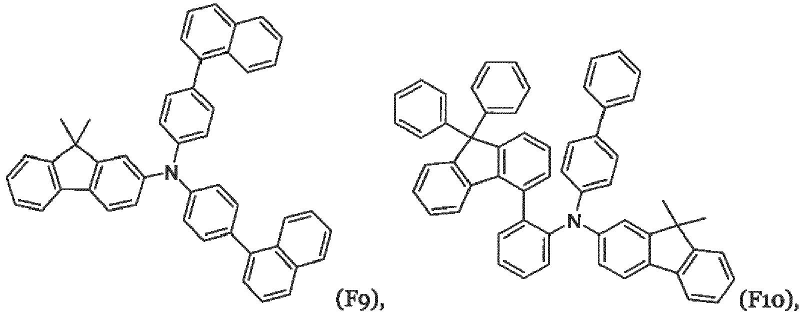

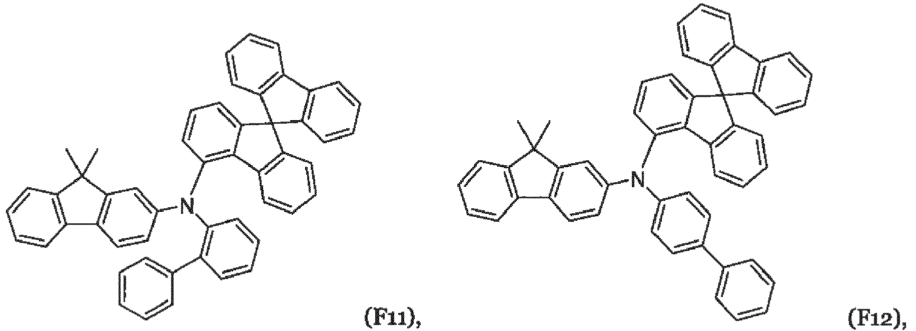

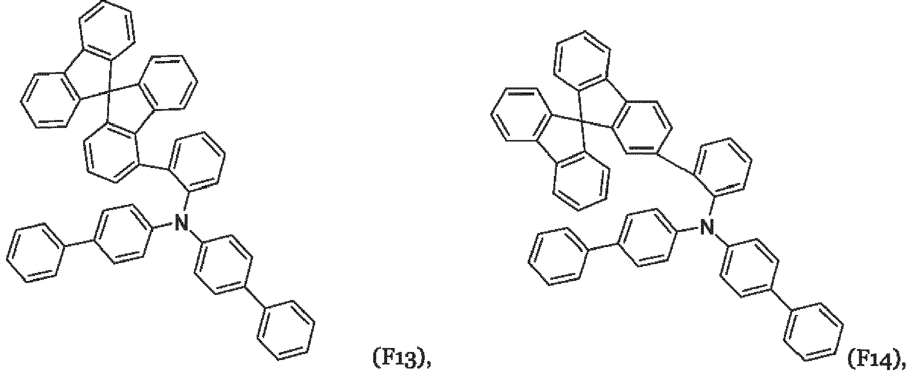

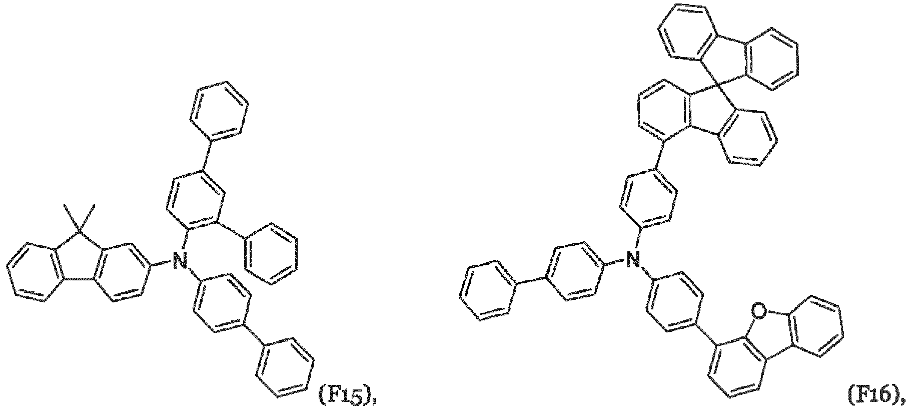

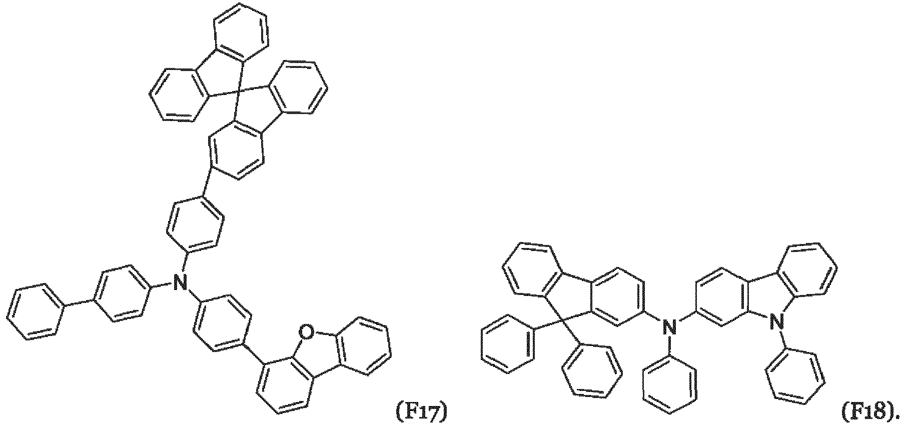

According to one embodiment of the present invention, Ar1' to Ar6' may be independently selected from a substituted or unsubstituted unsaturated 5- to 7-member ring of a heterocycle, a substituted or unsubstituted C₆ to C₃₀ aryl, a substituted or unsubstituted C₃ to C₃₀ heteroaryl, a substituted or unsubstituted fluorene, or a fused ring system comprising 2 to 6 substituted or unsubstituted 5- to 7-member rings and the rings are selected independently from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents are selected from the group H, D, C₁ to C₁₂ alkyl, unsubstituted C₆ to C₁₈ aryl, unsubstituted C₃ to C₁₈ heteroaryl, a fused ring system comprising 2 to 6 unsubstituted 5- to 7-member rings and the rings are independenty selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

According to one embodiment Ar¹' to Ar⁶' may be independently selected from substituted or unsubstituted biphenylene, substituted or unsubstituted fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted or unsubstituted azepine, substituted or unsubstituted dibenzo[b,f]azepine, 9,9'-spirobi[fluorene], substituted or unsubstituted spiro[fluorene-9,9'-xanthene], substituted or unsubstituted 9,14-dihydrodibenzo[2,3:6,7]azepino[4,5-b]indole, or a substituted or unsubstituted aromatic fused ring system comprising at least three substituted or unsubstituted aromatic rings independently selected from the group comprising substituted or unsubstituted non-hetero, substituted or unsubstituted hetero 5-member rings, substituted or unsubstituted 6-member rings and/or substituted or unsubstituted 7-member rings,
wherein the substituents are independently selected from the group H, D, C₁ to C₁₂ alkyl, unsubstituted C₆ to C₁₈ aryl, unsubstituted C₃ to C₁₈ heteroaryl, a fused ring system comprising 2 to 6 unsubstituted 5- to 7-member rings and the rings are independently selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

According to one embodiment compound of formula (11) may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

According to one embodiment, the compound of formula (11) may comprises at least ≥ 1 to ≤ 6 substituted or unsubstituted aromatic fused ring systems comprising heteroaromatic rings.

According to one embodiment, the compound of formula (11) may comprises at least ≥ 1 to ≤ 3 or 2 substituted or unsubstituted unsaturated 7-member ring of a heterocycle.

According to one embodiment, substituted or unsubstituted aromatic fused ring systems of the compound of formula (11) may comprises at least ≥ 1 to ≤ 3 or 2 substituted or unsubstituted unsaturated 5- to 7-member ring of a heterocycle.

According to one embodiment, the substituted or unsubstituted aromatic fused ring systems of the compound of formula (11) may comprises at least ≥ 1 to ≤ 3 or 2 substituted or unsubstituted unsaturated 7-member ring of a heterocycle.

According to one embodiment, the compound of formula (11) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises substituted or unsubstituted unsaturated 5- to 7-member ring of a heterocycle.

According to one embodiment, the compound of formula (11) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises substituted or unsubstituted unsaturated 5- to 7-member ring of a heterocycle.

According to one embodiment, the compound of formula (11) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises at least ≥ 1 to ≤ 3 or 2 substituted or unsubstituted unsaturated 5- to 7-member ring of a heterocycle.

According to one embodiment, the compound of formula (11) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises at least ≥ 1 to ≤ 3 or 2 substituted or unsubstituted unsaturated 5- to 7-member ring of a heterocycle.

According to one embodiment, the compound of formula (11) may comprises:
- a substituted or unsubstituted aromatic fused ring systems with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5- to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic ring and at least one substituted or unsubstituted unsaturated 5- to 7- member ring. It should be noted here that the substituted or unsubstituted unsaturated 5- to 7- member ring may not be an aromatic ring.

According to one embodiment, the compound of formula (11) may comprises at least at least ≥ 1 to ≤ 6, preferably ≥ 2 to ≤ 5, or further preferred 3 or 4 of the substituted or unsubstituted aromatic fused ring systems with:
- at least one unsaturated 5-member ring, and/or
- at least one unsaturated 6-member ring, and/or
- at least one unsaturated 7-member ring; wherein preferably at least one unsaturated 5- and/or at least one unsaturated 7-member ring comprises at least 1 to 3, preferably 1 hetero-atom.

According to one embodiment, the compound of formula (11) may comprises at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
wherein the substituted or unsubstituted aromatic fused ring system comprises at least ≥ 1 to ≤ 3 or 2 substituted or unsubstituted unsaturated 5- to 7-member ring of a heterocycle.

According to one embodiment, the compound of formula (11) may comprise:
- at least ≥ 6 to ≤ 12, preferably ≥ 7 to ≤ 11, further preferred ≥ 8 to ≤ 10 or 9 aromatic rings; and/or
- at least ≥ 4 to s 11, preferably ≥ 5 to ≤ 10, further preferred ≥ 6 to ≤ 9 or in addition preferred 7 or 8 non-hetero aromatic rings, preferably the non-hetero aromatic rings are aromatic C₆ rings; and/or
- at least ≥ 1 to ≤ 4, preferably 2 or 3 aromatic 5-member-rings, preferably hetero aromatic 5-member-rings; and/or
- at least 1 or 2 unsaturated 5- to 7-member-ring of a heterocycle, preferably at least 1 or 2 unsaturated 7-member-ring of a heterocycle;
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and/or
- at least ≥ 6 to ≤ 12, preferably ≥ 7 to ≤ 11, further preferred ≥ 8 to ≤ 10 or 9 aromatic rings, wherein therefrom
   at least ≥ 4 to ≤ 11, preferably ≥ 5 to ≤ 10, further preferred ≥ 6 to ≤ 9 or in addition preferred 7 or 8 are non-hetero aromatic rings, and
   at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and
      the hole transport compound or the hole transport compound according to formula I comprises at least ≥ 1 to ≤ 4, preferably 2 or 3 aromatic 5-member-rings, preferably hetero aromatic 5-member-rings, and/or
      the compound of formula (11) comprises at least 1 or 2 unsaturated 5- to 7-member-ring of a heterocycle, preferably at least 1 or 2 unsaturated 7-member-ring of a heterocycle.

According to one embodiment, the compound of formula (11) may comprises a hetero-atom, which may be selected from the group comprising O, S, N, B or P, preferably the hetero-atom may be selected from the group comprising O, S or N.

According to one embodiment, the compound of formula (11) may comprises at least at least ≥ 1 to ≤ 6, preferably ≥ 2 to ≤ 5, or further preferred 3 or 4 of the substituted or unsubstituted aromatic fused ring systems with:
- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;
wherein the substituted or unsubstituted aromatic fused ring system optional comprises at least ≥ 1 to ≤ 3 or 2 substituted or unsubstituted unsaturated 5- to 7-member ring of a heterocycle; and wherein the substituted or unsubstituted aromatic fused ring system comprises a hetero-atom, which may be selected from the group comprising O, S, N, B, P or Si, preferably the hetero-atom may be selected from the group comprising O, S or N.

According to one embodiment, compound of formula (11) may be free of hetero-atoms which are not part of an aromatic ring and/or part of an unsaturated 7-member-ring, preferably the compound of formula (11) may be free on N-atoms except N-atoms which are part of an aromatic ring or are part of an unsaturated 7-member-ring.

According to another embodiment, compound of formula (11) is represented by

(Ar^{1'})ᵣ-(Ar^{2'})ₛ-(Ar^{3'}-(Ar^{4'})ₚ-(Ar^{5'})_{q}-(Ar^{6'})ᵣ (11),

wherein
k, s, q, r may be independently selected from each other 0, 1 or 2,
p is 1, 2 or 3,
wherein 2 ≤ k+s+q+r+p ≤ 11,
Ar^{1'} to Ar^{6'} may be independently selected from substituted or unsubstituted unsaturated 5- to 7- member ring of a heterocycle, substituted or unsubstituted C₆ to C₃₀ aryl, substituted or unsubstituted C₃ to C₃₀ heteroaryl, a substituted or unsubstituted fluorene, or a fused ring system comprising 2 to 6 substituted or unsubstituted 5- to 7-member rings and the rings are independently selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
Ar² if k=1, Ar³, Ar⁴ if q = 1, Ar⁵ if r = 1: may be independently selected from substituted or unsubstituted unsaturated 5- to 7- member ring of a heterocycle, substituted or unsubstituted C₆ to C₃₀ arylene, substituted or unsubstituted C₃ to C₃₀ heteroarylene, substituted or unsubstituted biphenylene, substituted or unsubstituted fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted or unsubstituted azepine, substituted or unsubstituted dibenzo[b,f]azepine, 9,9'-spirobi[fluorene], substituted or unsubstituted spiro[fluorene-9,9'-xanthene], substituted or unsubstituted 9,14-dihydrodibenzo[2,3:6,7]azepino[4,5-b]indole, or a substituted or unsubstituted aromatic fused ring system comprising at least three, preferably three to six, substituted or unsubstituted aromatic rings independently selected from the group comprising substituted or unsubstituted non-hetero, substituted or unsubstituted hetero 5-member rings, substituted or unsubstituted 6-member rings and/or substituted or unsubstituted 7-member rings;
Ar² if k=o, Ar³ if s=o and k=o, Ar⁴ if q and r = o, Ar⁵ if r = o: may be independently selected from substituted or unsubstituted unsaturated 5- to 7- member ring of a heterocycle, substituted or unsubstituted C₆ to C₃₀ aryl, substituted or unsubstituted C₃ to C₃₀ heteroaryl, substituted or unsubstituted biphenyl, substituted or unsubstituted fluorenyl, substituted or unsubstituted naphthalenyl, substituted or unsubstituted anthracenyl, substituted or unsubstituted phenanthrenyl, substituted or unsubstituted pyrenyl, substituted or unsubstituted perylenyl, substituted or unsubstituted triphenylenyl, substituted or unsubstituted tetracenyl, substituted or unsubstituted tetraphenyl, substituted or unsubstituted dibenzofuranyl, substituted or unsubstituted dibenzothiophenyl, substituted or unsubstituted xanthenyl, substituted or unsubstituted carbazole, substituted or unsubstituted azepine, substituted or unsubstituted dibenzo[b,f]azepine, 9,9'-spirobi[fluorenyl], substituted or unsubstituted spiro[fluorenyl-9,9'-xanthene], substituted or unsubstituted 9,14-dihydrodibenzo[2,3:6,7]azepino[4,5-b]indole, or a substituted or unsubstituted aromatic fused ring system comprising at least three preferably three to six, substituted or unsubstituted aromatic rings independently selected from the group comprising substituted or unsubstituted non-hetero, substituted or unsubstituted hetero 5-member rings, substituted or unsubstituted 6-member rings and/or substituted or unsubstituted 7-member rings;
   wherein the substituents are selected from the group H, D, C₁ to C₁₂ alkyl, unsubstituted C₆ to C₁₈ aryl, or unsubstituted C₃ to C₁₈ heteroaryl.

### Layer structure

According to one embodiment of the present invention, the organic electroluminescent device further comprises a hole transport layer, wherein the hole transport layer is the organic semiconductor layer comprising the compound of formula (1).

According to one embodiment of the present invention, the organic electroluminescent device further comprises an electron blocking layer, wherein the electron blocking layer is the organic semiconductor layer comprising the compound of formula (1).

According to one embodiment of the present invention, the organic electroluminescent device comprises further a hole transport layer, which may contain a compound of formula (6), (7) and (8) as described above, in particular if the device further comprises an electron blocking layer and the electron blocking layer comprises a compound of formula (1).

According to one embodiment of the present invention, the organic electroluminescent device further comprises a hole transport layer and an electron blocking layer, wherein both the hole transport layer and the electron blocking layer are the organic semiconductor layer comprising the compound of formula (1).

According to one embodiment of the present invention, the organic electroluminescent device further comprises a hole transport layer and an electron blocking layer, wherein the hole injection layer, the hole transport layer and the electron blocking layer are each the organic semiconductor layer comprising the compound of formula (1).

According to one embodiment of the present invention, the organic semiconductor layer is a hole transport layer; and
- the organic semiconductor layer may be adjacent to the hole injection layer; and/or
- the organic semiconductor layer may be in direct contact to the hole injection layer; and/or
- the organic electroluminescent device further comprises an electron blocking layer, and the organic semiconductor layer may be in direct contact to the hole injection layer and in direct contact with the electron blocking layer.

According to one embodiment of the present invention, the organic semiconductor layer is a electron blocking layer; and
- the organic electroluminescent device further comprises a hole transport layer and the organic semiconductor layer may be adjacent to the hole transport layer and adjacent to the at least one light-emitting layer; and/or
- the organic electroluminescent device further comprises a hole transport layer and the organic semiconductor layer may in direct contact to the hole transport layer and in direct contact to the at least one light-emitting layer.

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Anode layer

The anode layer may be formed by depositing or sputtering a material that is used to form the anode electrode. The material used to form the anode electrode may be a high work-function material, so as to facilitate hole injection. The anode material may also be selected from a low work function material (i.e. aluminum). The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

According to a preferred embodiment the organic electrode device comprises an anode layer, whereby the anode layer comprises a first anode sub-layer and a second anode sub-layer, wherein
- the first anode sub-layer comprises a first metal having a work function in the range of ≥ 4 and ≤ 6 eV, and
- the second anode sub-layer comprises a transparent conductive oxide; and
- the second anode sub-layer is arranged closer to the hole injection layer.

According to one embodiment of the present invention, the first metal of the first anode sub-layer may be selected from the group comprising Ag, Mg, Al, Cr, Pt, Au, Pd, Ni, Nd, Ir, preferably Ag, Au or Al, and more preferred Ag.

According to one embodiment of the present invention, the first anode sub-layer has have a thickness in the range of 5 to 200 nm, alternatively 8 to 180 nm, alternatively 8 to 150 nm, alternatively 100 to 150 nm.

According to one embodiment of the present invention, the first anode sub-layer is formed by depositing the first metal via vacuum thermal evaporation.

It is to be understood that the first anode layer is not part of the substrate.

According to one embodiment of the present invention, the transparent conductive oxide of the second anode sub layer is selected from the group selected from the group comprising indium tin oxide or indium zinc oxide, more preferred indium tin oxide.

According to one embodiment of the present invention, the second anode sub-layer may have a thickness in the range of 3 to 200 nm, alternatively 3 to 180 nm, alternatively 3 to 150 nm, alternatively 3 to 20 nm.

According to one embodiment of the present invention, the second anode sub-layer may be formed by sputtering of the transparent conductive oxide.

According to one embodiment of the present invention, anode layer of the organic electronic device comprises in addition a third anode sub-layer comprising a transparent conductive oxide, wherein the third anode sub-layer is arranged between the substrate and the first anode sub-layer.

According to one embodiment of the present invention, the third anode sub-layer comprises a transparent oxide, preferably from the group selected from the group comprising indium tin oxide or indium zinc oxide, more preferred indium tin oxide.

According to one embodiment of the present invention, the third anode sub-layer may have a thickness in the range of 3 to 200 nm, alternatively 3 to 180 nm, alternatively 3 to 150 nm, alternatively 3 to 20 nm.

According to one embodiment of the present invention, the third anode sub-layer may be formed by sputtering of the transparent conductive oxide.

It is to be understood that the third anode layer is not part of the substrate.

According to one embodiment of the present invention, the hole injection layer is in direct contact with the anode layer.

### Hole injection layer

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris(3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-i-yl)-N,N'-bis(phenyl)-benzidine) doped with F4TCNQ. α-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Hole transport layer

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-i-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment of the present invention, the hole transport layer may be the semiconductor layer of the present invention.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime may be improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

According to one embodiment of the present invention, the electron blocking layer may be the semiconductor layer of the present invention.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Photoactive layer (PAL)

The photoactive layer converts an electrical current into photons or photons into an electrical current.

The PAL may be formed on the HTL by vacuum deposition, spin coating, slot-die coat-ing, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

It may be provided that the photoactive layer does not comprise the compound of Formula (1).

The photoactive layer may be a light-emitting layer or a light-absorbing layer.

### Emission layer (EML)

The EML may be formed on the HTL by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

It may be provided that the emission layer does not comprise the compound of Formula (1).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzirniclazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode electrode

The cathode electrode is formed on the ETL or optional EIL. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

It is to be understood that the cathode electrode is not part of an electron injection layer or the electron transport layer.

### Organic light-emitting diode (OLED)

The organic electroluminescent device according to the invention may be an organic light-emitting device.

According to one aspect of the present invention, there is provided an organic light-emitting diode (OLED) comprising: a substrate; an anode electrode formed on the substrate; a hole injection layer, an semiconductor layer comprising compound of formula (1), an emission layer, an electron transport layer and a cathode electrode.

According to another aspect of the present invention, there is provided an OLED comprising: a substrate; an anode electrode layer formed on the substrate; ; a hole injection layer; a semiconductor layer comprising a compound of Formula (1), an electron blocking layer, an emission layer, a hole blocking layer, an electron transport layer and a cathode layer.

According to another aspect of the present invention, there is provided an OLED comprising: a substrate; an anode electrode layer formed on the substrate; a hole injection layer, a hole transport layer, a semiconductor layer comprising a compound of Formula (1), an emission layer, a hole blocking layer, an electron transport layer and a cathode layer.

According to another aspect of the present invention, there is provided an OLED comprising: a substrate; an anode layer formed on the substrate; a hole injection layer, a semiconductor layer comprising a compound of Formula (1), a hole injection layer or an electron blocking layer, an emission layer, a hole blocking layer, an electron transport layer, an electron injection layer, and a cathode layer.

According to various embodiments of the present invention, there may be provided OLEDs layers arranged between the above mentioned layers, on the substrate or on the top layer.

According to one aspect, the OLED may comprise a layer structure of a substrate that is adjacent arranged to an anode layer, the anode layer is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode layer an optional electron transport layer and/or an optional injection layer are arranged.

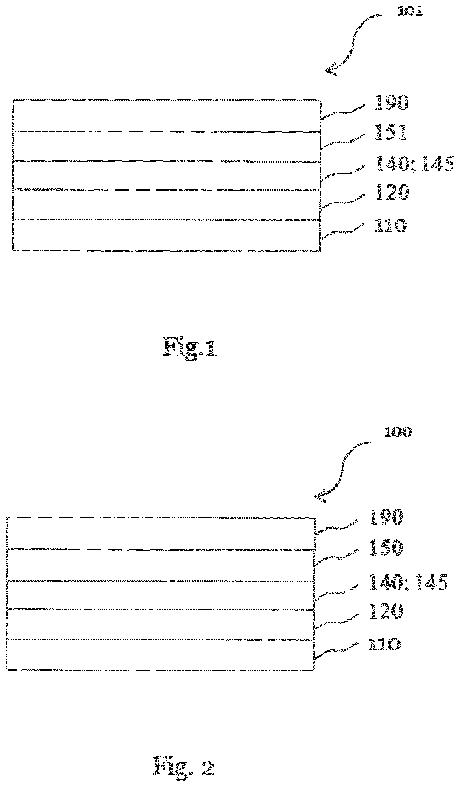

For example, the OLED according to Fig. 2 may be formed by a process, wherein on a substrate (110), an anode layer (120), a hole injection layer (130), a hole transport layer (140), an electron blocking layer (145), an emission layer (150), a hole blocking layer (155), an electron transport layer (160), an electron injection layer (180) and the cathode layer (190) are subsequently formed in that order, wherein preferably the hole transport layer (140) and/or the electron blocking layer (145) are the semiconductor layer comprising the compound of formula (1).

### Display device

The present invention furthermore relates to a display device comprising an organic electroluminescent device according to the present invention.

### Compound

The present invention furthermore relates to a represented by formula (1a) 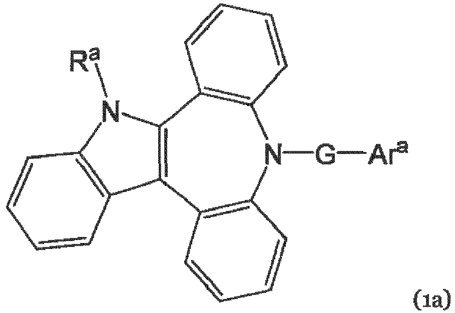 wherein
- R^{a} is selected from an unsubstituted C₆ to C₁₂ aryl, or an unsubstituted C₁ to C₁₈ alkyl;
- G is selected from a substituted or unsubstituted C₆ to C₁₂ aryl;
- Ar^{a} is selected from a substituted or unsubstituted C₁₃ to C₂₄ aryl comprising o to 3 fused rings, wherein, if the C₁₃ to C₂₄ aryl comprising o to 3 fused rings is substituted, the one or more substituents are independently selected from C₁ to C₁₈ alkyl, or C₆ to C₁₂ aryl; or a group of formula (2c); or a group of formula (2b); 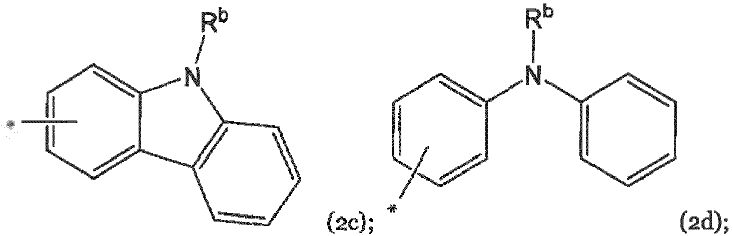 and
- R^{b} is selected from an unsubstituted C₆ to C₃₆ aryl; or an unsubstituted C₁ to C₁₈ alkyl.

### R^{a}

According to one embodiment of the present invention, R^{a} is selected from a substituted or unsubstituted C₆ to C₁₀ aryl; or a substituted or unsubstituted C₁ to C₁₂ alkyl, alternatively a substituted or unsubstituted C₁ to C₁₀ alkyl, alternatively a substituted or unsubstituted C₁ to C₈ alkyl, alternatively a substituted or unsubstituted C₁ to C₆ alkyl, alternatively a substituted or unsubstituted C₁ to C₄ alkyl.

According to one embodiment of the present invention, R^{a} is selected from an unsubstituted C₆ to C₁₀ aryl; or an unsubstituted C₁ to C₁₂ alkyl, alternatively an unsubstituted C₁ to C₁₀ alkyl, alternatively an unsubstituted C₁ to C₈ alkyl, alternatively an unsubstituted C₁ to C₆ alkyl, alternatively an unsubstituted C₁ to C₄ alkyl.

According to one embodiment of the present invention, R^{a} is selected from

| | | |
|---|---|---|
| 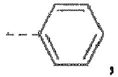 | 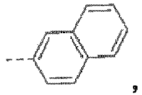 | 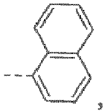 |
| 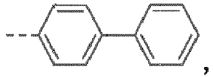 | 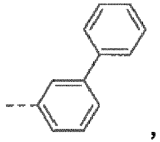 | 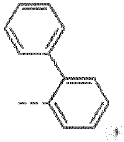 |
| -CH₃ | -C₂H₅ | -C₃H₇ |
| -C(CH₃)₂ | -C₄H₉ | -C(CH₃)₃ |
| -CH(CH₃)(C₂H₅) | | |

According to one embodiment of the present invention, R^{a} is selected from

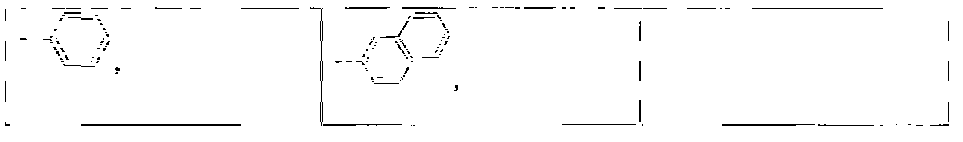

### G

According to one embodiment of the present invention, G is selected from a substituted or unsubstituted C₆ to C₁₀ aryl.

According to one embodiment of the present invention, G is selected from an unsubstituted C₆ to C₁₂ aryl.

According to one embodiment of the present invention, G is selected from an unsubstituted C₆ to C₁₀ aryl.

According to one embodiment of the present invention, G is selected from

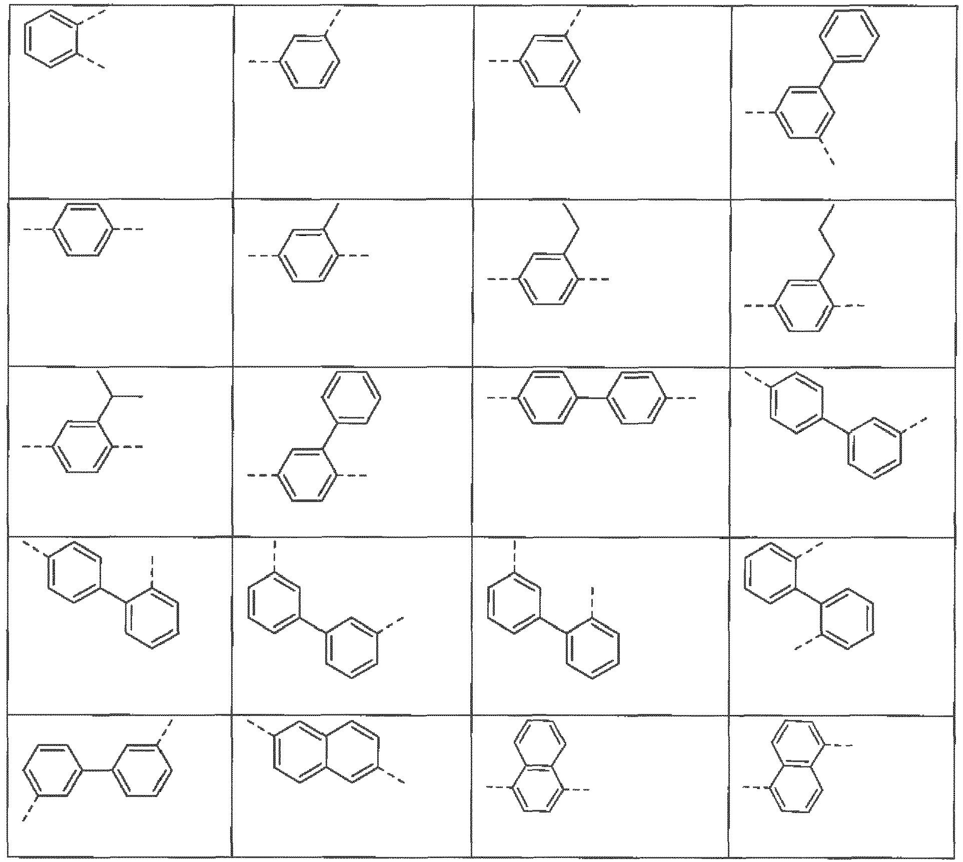

According to one embodiment of the present invention, G is selected from

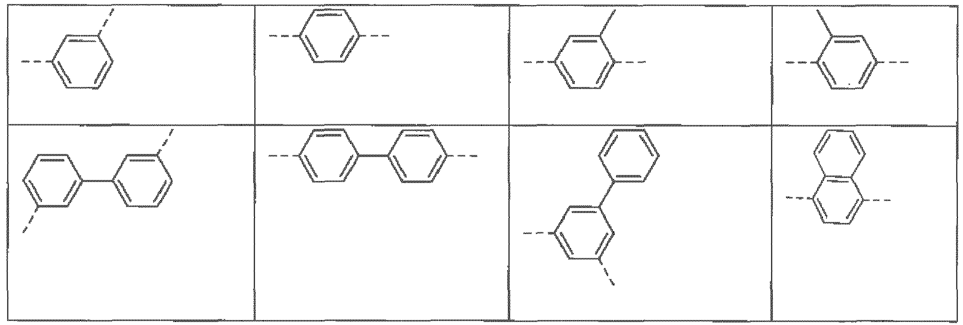

According to one embodiment of the present invention, G is selected from

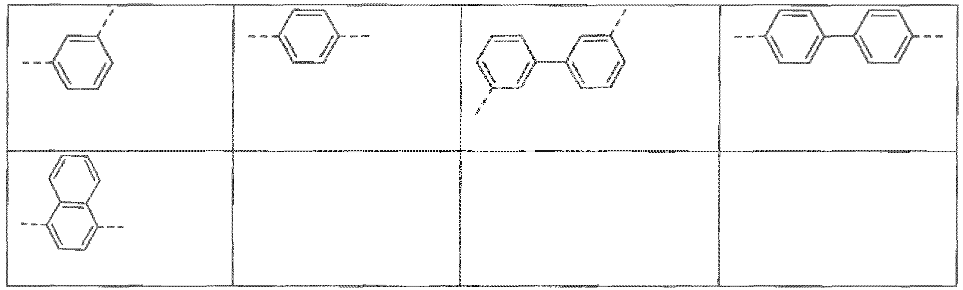

In case that the aryl in G is substituted, the one or more substituents can be selected independently from C₁ to C₁₈ alkyl, C₆ to C₁₂ aryl or C₃ to C₁₂ heteroaryl. Alternatively in case that the aryl in G is substituted, the one or more substituents can be selected independently from C₁ to C₁₈ alkyl or C₆ to C₁₂ aryl. Alternatively in case that the aryl in G is substituted, the one or more substituents can be selected independently from C₁ to C₁₈ alkyl or C₆ to C₁₀ aryl. Alternatively in case that the aryl in G is substituted, the one or more substituents can be selected independently from C₁ to C₁₈ alkyl or phenyl. Alternatively in case that the aryl in G is substituted, the one or more substituents can be selected independently from C₁ to C₁₂ alkyl, alternatively C₁ to C₁₀ alkyl, alternatively C₁ to C₈ alkyl, alternatively C₁ to C₆ alkyl, alternatively C₁ to C₄ alkyl.

### Ar^{a}

According to one embodiment of the present invention, Ar^{a} is selected from

According to one embodiment of the present invention, substituted or unsubstituted aryl comprising o to 3 fused rings, the aryl may be C₁₃ to C₂₂ aryl, alternatively C₁₃ to C₂₀ aryl, alternatively C₁₃ to C₁₈ aryl.

In case that the aryl in Ar^{a} is substituted, the one or more substituents can be selected independently from C₁ to C₁₈ alkyl, C₆ to C₁₂ aryl or C₃ to C₁₂ heteroaryl. In case that the aryl in Ar^{a} is substituted, the one or more substituents can be selected independently from C₁ to C₁₈ alkyl and C₆ to C₁₂ aryl. In case that the aryl in Ar^{a} is substituted, the one or more substituents can be selected independently selected from C₁ to C₁₂ alkyl, alternatively C₁ to C₁₀ alkyl, alternatively C₁ to C₈ alkyl, alternatively C₁ to C₆ alkyl, alternatively C₁ to C₄ alkyl.

According to one embodiment of the present invention, Ar^{a} is selected from a substituted or unsubstituted C₆ to C₂₄ aryl, alternatively C₆ to C₁₈ aryl, alternatively C₆ to C₁₂ aryl, alternatively C₆ aryl; or a substituted or unsubstituted C₁ to C₁₂ alkyl, alternatively C₁ to C₁₀ alkyl, alternatively C₁ to C₈ alkyl, alternatively C₁ to C₆ alkyl, alternatively C₁ to C₄ alkyl.

According to one embodiment of the present invention, Ar^{a} is selected from

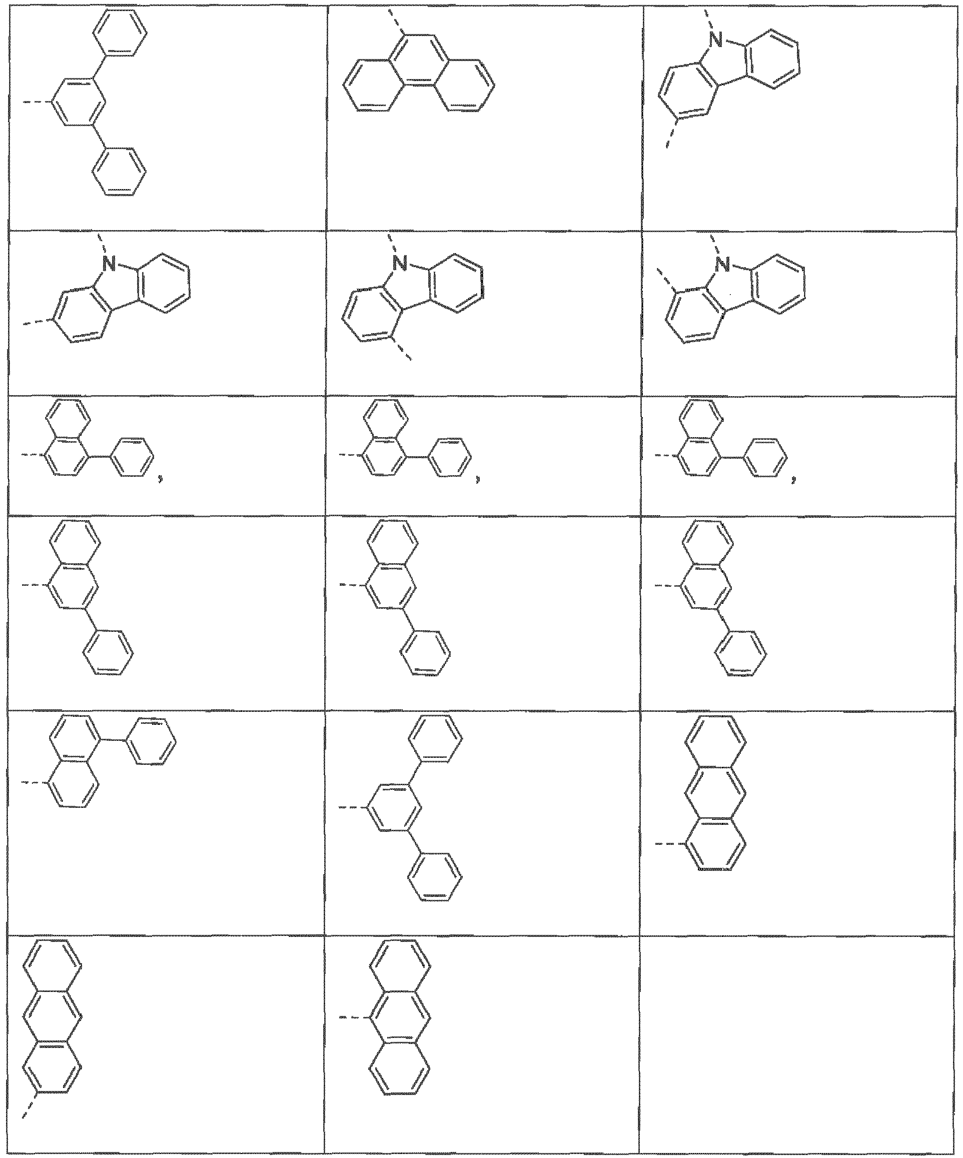

According to one embodiment of the present invention, Ar^{a} is selected from

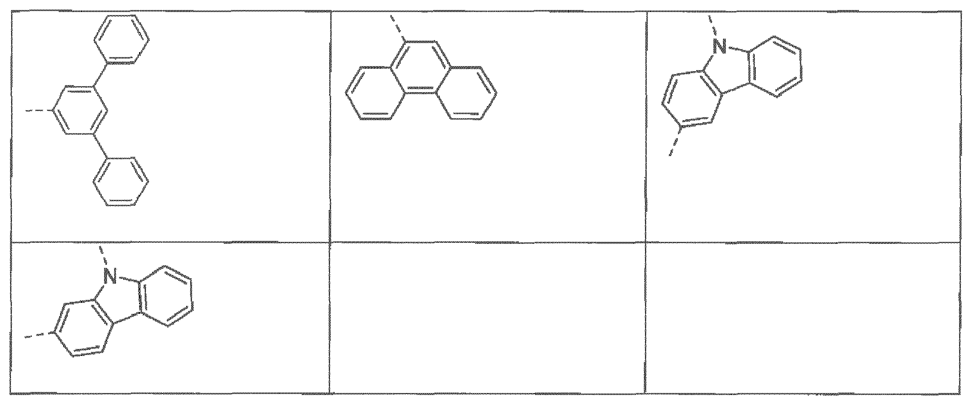

In the above tables, the dashed lines represent the binding positions to the remaining structure of formula (1).

According to one embodiment of the present invention, R^{b} is selected from

| | | |
|---|---|---|
| 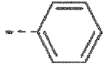 | 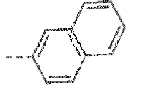 | 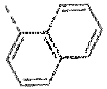 |
| 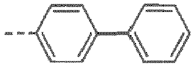 | 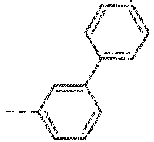 | 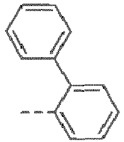 |
| -CH₃ | -C₂H₅ | -C₃H₇ |
| -C(CH₃)₂ | -C₄H₉ | -C(CH₃)₃ |
| -CH(CH₃)(C₂H₅) | | |

According to one embodiment of the present invention, R^{b} is selected from

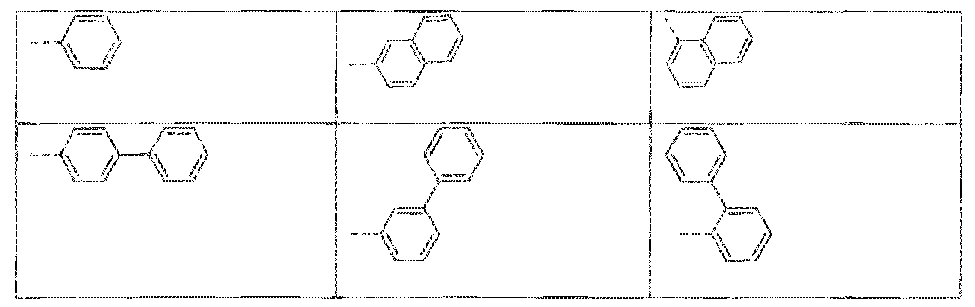

According to one embodiment of the present invention, R^{b} is selected from

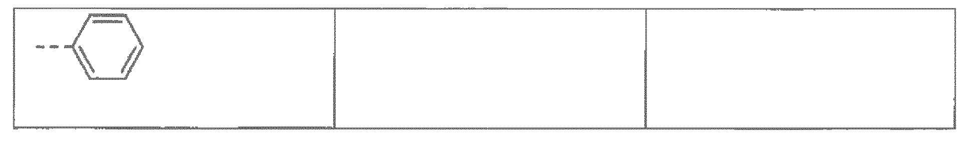

According to one embodiment of the present invention, the compound of formula (1a) in the organic semiconductor layer is represented by one of the formulas A1 to A14

| | | |
|---|---|---|
| 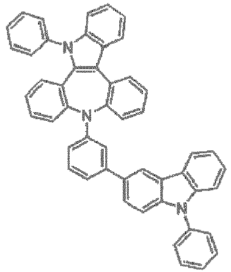 | 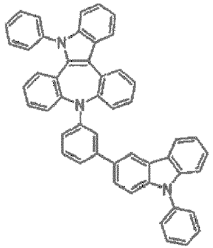 | 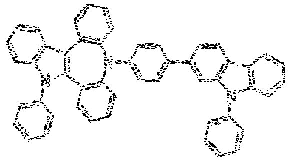 |
| A1 | A2 | A3 |
| 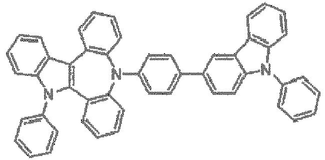 | 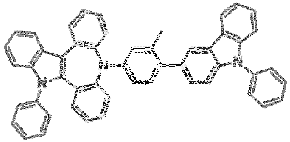 | 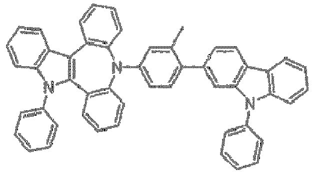 |
| A4 | A5 | A6 |
| 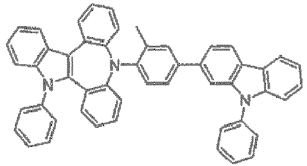 | 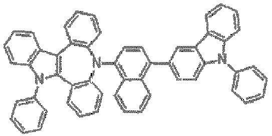 | 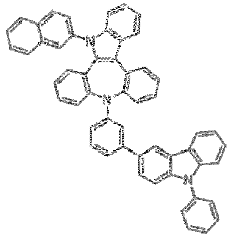 |
| A 7 | A8 | A9 |
| 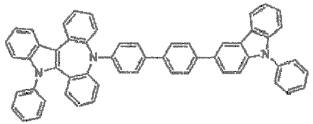 | 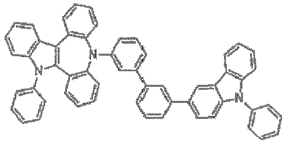 | 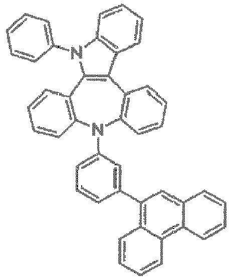 |
| A10 | A11 | A12 |
| 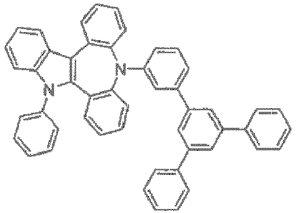 | 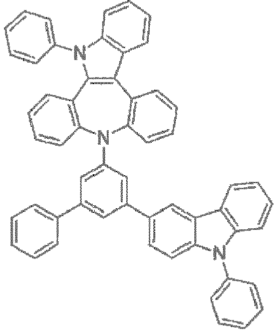 | |
| A13 | A14 | |

### R^{b}

According to one embodiment of the present invention, R^{b} is selected from a substituted or unsubstituted C₆ to C₂₄ aryl, alternatively C₆ to C₁₈ aryl; or a substituted or unsubstituted C₁ to C₁₂ alkyl, alternatively C₁ to C₁₀ alkyl, alternatively C₁ to C₈ alkyl, alternatively C₁ to C₆ alkyl, alternatively C₁ to C₄ alkyl.

### Further embodiments

According to one embodiment of the present invention, there is provided an organic electroluminescent device comprising an anode layer, a cathode layer, a hole injection layer, at least one light-emitting layer and an organic semiconductor layer; wherein the organic semiconductor layer is arranged between the hole injection layer and the at least one light-emitting layer;
wherein
- the organic semiconductor layer comprises a compound of formula (1) 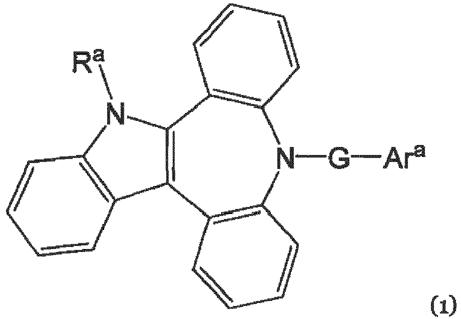
- R^{a} is selected from a substituted or unsubstituted C₆ to C₁₈ aryl, or a substituted or unsubstituted C₁ to C₁₈ alkyl;
- G is selected from a substituted or unsubstituted C₆ to C₁₂ aryl;
- Ar^{a} is selected from a substituted or unsubstituted C₁₃ to C₂₄ aryl comprising o to 3 fused rings; a group of formula (2a); or a group of formula (2b); 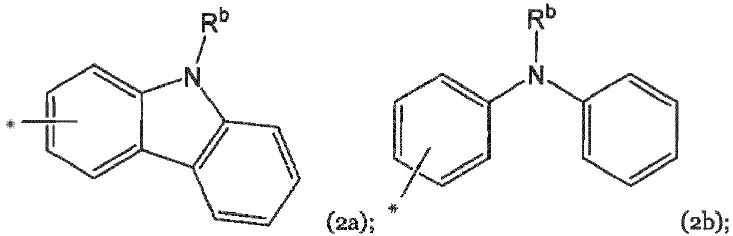
- R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl; and
- the hole injection layer comprises hole injection material and a matrix material, wherein the hole injection layer is free of CuPc.

According to one embodiment of the present invention, there is provided an organic electroluminescent device comprising an anode layer, a cathode layer, a hole injection layer, at least one light-emitting layer and an organic semiconductor layer; wherein the organic semiconductor layer is arranged between the hole injection layer and the at least one light-emitting layer;
wherein
- the organic semiconductor layer comprises a compound of formula (1) 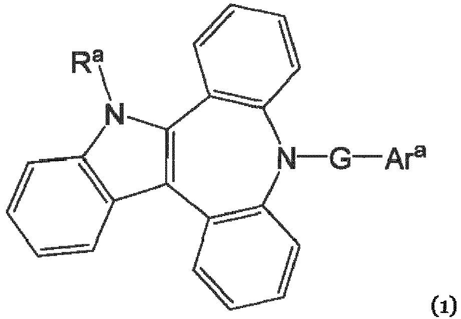
- R^{a} is selected from a substituted or unsubstituted C₆ to C₁₈ aryl, or a substituted or unsubstituted C₁ to C₁₈ alkyl;
- G is selected from a substituted or unsubstituted C₆ to C₁₂ aryl;
- Ar^{a} is selected from a substituted or unsubstituted C₁₃ to C₂₄ aryl comprising o to 3 fused rings; a group of formula (2a); or a group of formula (2b); 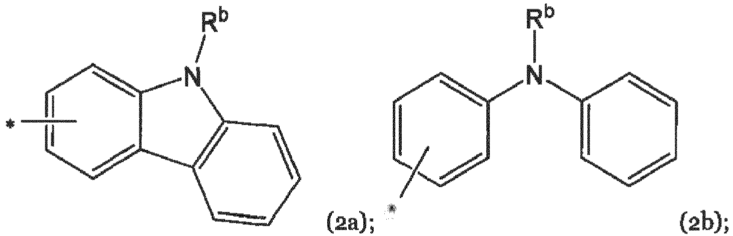
- R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl; and
- the hole injection layer comprises hole injection material and a matrix material, wherein the hole injection material comprises a compound of formula (3) and/or a compound of formula (4)

   M^{n⊕} (L^{⊖})ₙ (3)

   wherein in formula (3)
- M is a metal ion;
- n is the valency of M, and n is an integer from 1 to 4; and
- L is a ligand comprising at least two carbon atoms; 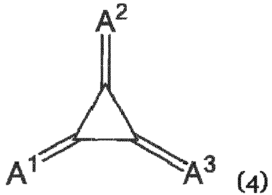 wherein in formula (4)
- A¹, A² and A³ are independently selected from a group (4a) 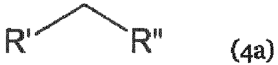
- each R' is independently selected from substituted or unsubstituted C₆ to C₃₆ aryl and substituted or unsubstituted C₂ to C₃₆ heteroaryl;
- if R' is substituted, the one or more substituents are independently selected from an electron-withdrawing group, preferably from F, CN, perfluorinated alkyl, most preferred CF₃; and
- each R" is independently selected from an electron-withdrawing group, preferably from CN, or perfluorinated alkyl, preferably from CF₃, NO₂, or F.

According to one embodiment of the present invention, there is provided an organic electroluminescent device comprising an anode layer, a cathode layer, a hole injection layer, at least one light-emitting layer and an organic semiconductor layer; wherein the organic semiconductor layer is arranged between the hole injection layer and the at least one light-emitting layer;
wherein
- the organic semiconductor layer comprises a compound of formula (1) 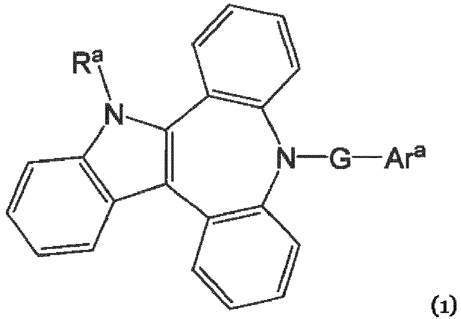
- R^{a} is selected from a substituted or unsubstituted C₆ to C₁₈ aryl, or a substituted or unsubstituted C₁ to C₁₈ alkyl;
- G is selected from a substituted or unsubstituted C₆ to C₁₂ aryl;
- Ar^{a} is selected from a substituted or unsubstituted C₁₃ to C₂₄ aryl comprising o to 3 fused rings; a group of formula (2a); or a group of formula (2b); 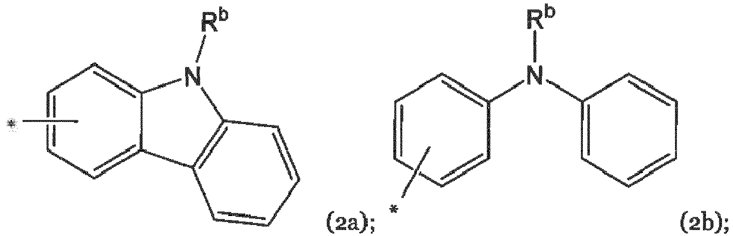
- R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl; and
- the hole injection layer comprises hole injection material and a matrix material, wherein the hole injection layer is free of CuPc.

According to one embodiment of the present invention, there is provided an organic electroluminescent device comprising an anode layer, a cathode layer, a hole injection layer, at least one light-emitting layer and an organic semiconductor layer; wherein the organic semiconductor layer is arranged between the hole injection layer and the at least one light-emitting layer;
wherein
- the organic semiconductor layer comprises a compound of formula (1) 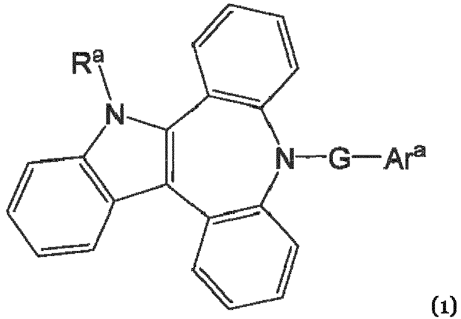
- R^{a} is selected from a substituted or unsubstituted C₆ to C₁₈ aryl, or a substituted or unsubstituted C₁ to C₁₈ alkyl;
- G is selected from a substituted or unsubstituted C₆ to C₁₂ aryl;
- Ar^{a} is selected from a substituted or unsubstituted C₁₃ to C₂₄ aryl comprising o to 3 fused rings; a group of formula (2a); or a group of formula (2b); 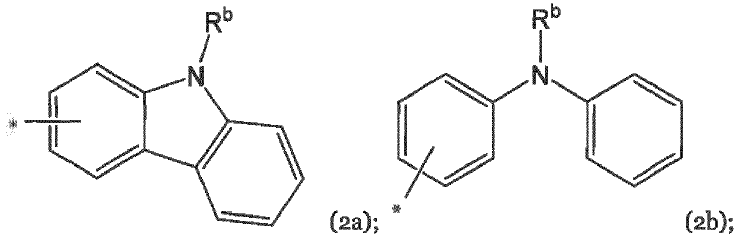
- R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl; and
- the hole injection layer comprises hole injection material and a matrix material, wherein the matrix material of the hole injection layer comprises a compound of formula (6), a compound of formula (7); a compound of formula (8), a compound of formula (11) or mixtures thereof; 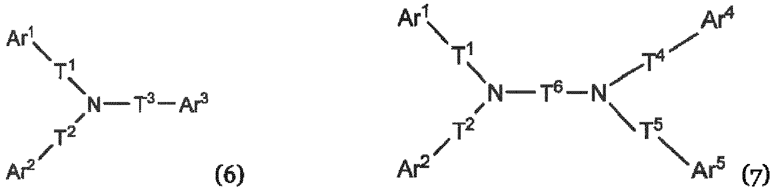 wherein in formulas (6) and (7)
- T¹, T², T³, T⁴ and T⁵ are independently selected from a single bond, phenylene, biphenylene, terphenylene or naphthenylene, preferably a single bond or phenylene;
- T⁶ is phenylene, biphenylene, terphenylene or naphthenylene;
- Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, preferably from substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are independently selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
- If one or more of Ar¹, Ar², Ar³, Ar⁴ and Ar⁵ is/are substituted, the one ore more substituents is/are independently selected from H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are independently selected from the group comprising unsaturated 5- to 7-member ring of a heterocycle, 5-to 6-member of an aromatic heterocycle, unsaturated 5- to 7-member ring of a non-heterocycle, and 6-member ring of an aromatic non-heterocycle, wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl; 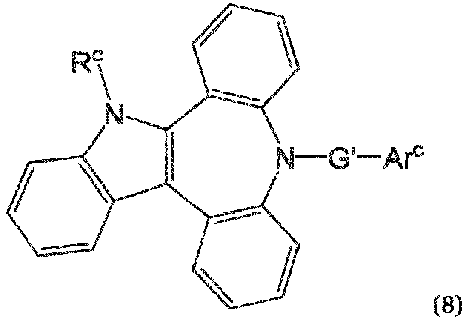 wherein in formula (8)
   - R^{c} is selected from substituted or unsubstituted aryl, substituted or unsubstituted heteroaryl, substituted or unsubstituted alkyl;
   - G' is selected from a substituted or unsubstituted C₆ to C₁₈ aryl and C₃ to C₁₈ heteroaryl; and
   - Ar^{c} is selected from a substituted or unsubstituted C₆ to C₂₄ aryl comprising o to 3 fused rings; a or C₃ to C₂₄ heteroaryl comprising o to 3 fused rings; a group of formula (9a); or a group of formula (9b); 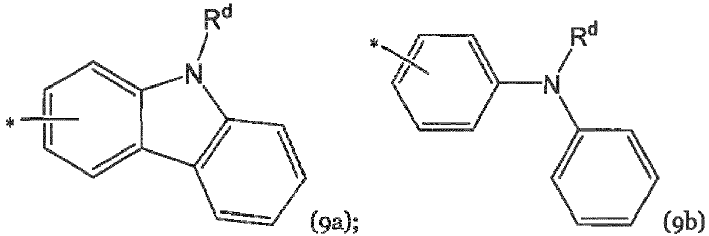
   - R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl;

      (Ar^{1'})ₖ-(Ar^{2'})ₛ-Ar^{3'}-(Ar^{4'})ₚ-(Ar^{5'})_{q}-(Ar^{6'})ᵣ (11),
   - wherein in formula (11)
   - k, s, q, r are independently selected from each other 0, 1 or 2,
   - p is 1, 2 or 3,
   - wherein 2 ≤ k+s+q+r+p ≤ 11,
   - Ar^{1'} to Ar^{6'} are independently selected from a substituted or unsubstituted unsaturated 5- to 7-member ring of a heterocycle, a substituted or unsubstituted C₆ to C₃₀ aryl, a substituted or unsubstituted C₃ to C₃₀ heteroaryl, a substituted or unsubstituted fluorene, or a fused ring system comprising 2 to 6 substituted or unsubstituted 5- to 7-member rings and the rings are independently selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle; preferably independently selected from substituted or unsubstituted biphenylene, substituted or unsubstituted fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted or unsubstituted azepine, substituted or unsubstituted dibenzo[b,f]azepine, 9,9'-spirobi[fluorene], substituted or unsubstituted spiro[fluorene-9,9'-xanthene], substituted or unsubstituted 9,14-dihydrodibenzo[2,3:6,7]azepino[4,5-b]indole, or a substituted or unsubstituted aromatic fused ring system comprising at least three substituted or unsubstituted aromatic rings independently selected from the group comprising substituted or unsubstituted non-hetero, substituted or unsubstituted hetero 5-member rings, substituted or unsubstituted 6-member rings and/or substituted or unsubstituted 7-member rings,
   - wherein the substituents are selected from the group H, D, C₁ to C₁₂ alkyl, unsubstituted C₆ to C₁₈ aryl, unsubstituted C₃ to C₁₈ heteroaryl, a fused ring system comprising 2 to 6 unsubstituted 5- to 7-member rings and the rings are independently selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

According to one embodiment of the present invention, there is provided an organic electroluminescent device comprising an anode layer, a cathode layer, a hole injection layer, at least one light-emitting layer and an organic semiconductor layer; wherein the organic semiconductor layer is arranged between the hole injection layer and the at least one light-emitting layer;
wherein
- the organic semiconductor layer comprises a compound of formula (1) 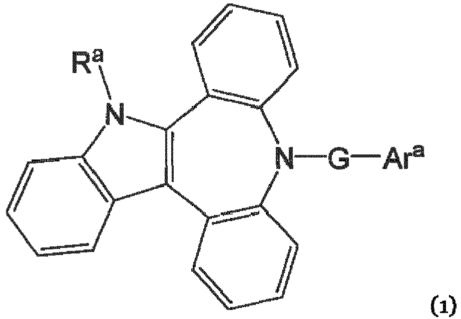
- R^{a} is selected from a substituted or unsubstituted C₆ to C₁₈ aryl, or a substituted or unsubstituted C₁ to C₁₈ alkyl;
- G is selected from a unsubstituted C₆ to C₁₂ aryl;
- Ar^{a} is selected from a substituted or unsubstituted C₁₃ to C₂₄ aryl comprising o to 3 fused rings; a group of formula (2a); or a group of formula (2b); 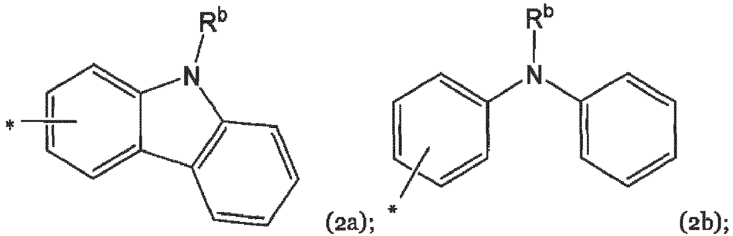
- R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl; and
- the hole injection layer comprises hole injection material and a matrix material.

According to one embodiment of the present invention, there is provided a compound of formula (1a) 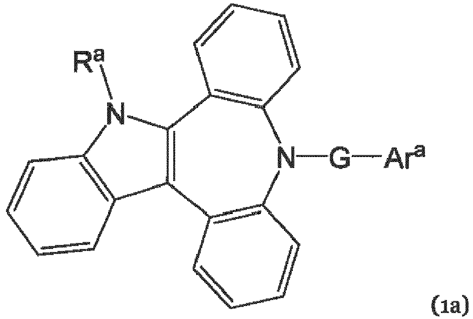
- R^{a} is selected from a substituted or unsubstituted C₆ to C₁₂ aryl, or a substituted or unsubstituted C₁ to C₁₈ alkyl;
- G is selected from a unsubstituted C₆ to C₁₂ aryl;
- Ar^{a} is selected from a substituted or unsubstituted C₁₃ to C₂₄ aryl comprising o to 3 fused rings; a group of formula (2c); or a group of formula (2d); 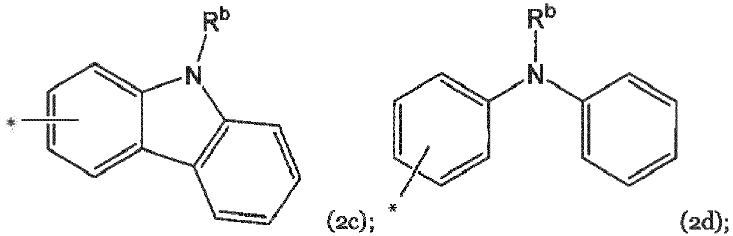
- R^{b} is selected from a substituted or unsubstituted C₆ to C₃₆ aryl; or a substituted or unsubstituted C₁ to C₁₈ alkyl.

### DESCRIPTION OF THE DRAWINGS

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.
FIG. 1 is a schematic sectional view of an organic electronic device, according to an exemplary embodiment of the present invention;
FIG. 2 is a schematic sectional view of an organic light-emitting diode (OLED), according to an exemplary embodiment of the present invention;
FIG. 3 is a schematic sectional view of an organic light-emitting diode (OLED), according to an exemplary embodiment of the present invention.
FIG. 4 is a schematic sectional view of an organic light-emitting diode (OLED), according to an exemplary embodiment of the present invention;
FIG. 5 is a schematic sectional view of an organic light-emitting diode (OLED), according to an exemplary embodiment of the present invention.
FIG. 6 is a schematic sectional view of an organic light-emitting diode (OLED), according to an exemplary embodiment of the present invention.

Hereinafter, the figures 1 to 6 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device 101, according to an exemplary embodiment of the present invention. The organic electronic device 101 includes a substrate (110), an anode layer (120), a semiconductor layer comprising a compound of Formula (1) (140; 145), a photoactive layer (PAL) (151) and a cathode layer (190).

FIG. 2 is a schematic sectional view of an organic light-emitting diode (OLED) 100, according to an exemplary embodiment of the present invention. The OLED 100 includes a substrate (110), an anode layer (120), a semiconductor layer comprising a compound of Formula (1) (140; 145), an emission layer (EML) (150) and a cathode layer (190).

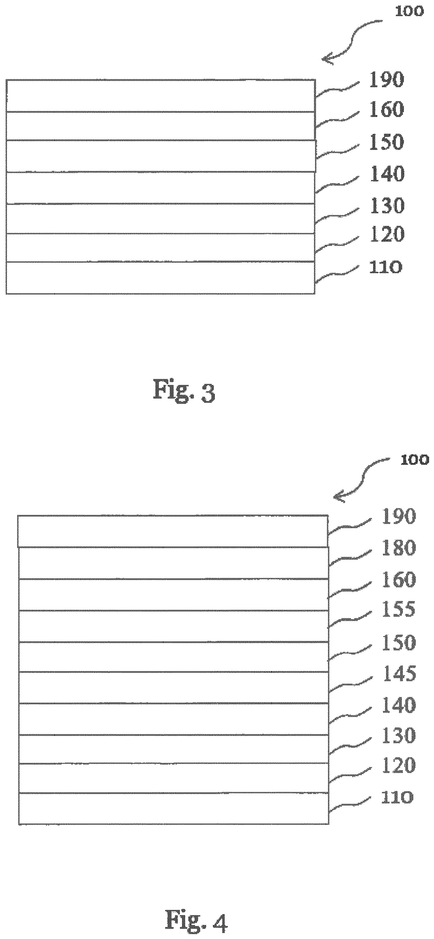

FIG. 3 is a schematic sectional view of an organic light-emitting diode (OLED) 100, according to an exemplary embodiment of the present invention. The OLED 100 includes a substrate (110), an anode layer (120), a hole injection layer (130), a semiconductor layer comprising a compound of Formula (1) (140), an emission layer (EML) (150), an electron transport layer (ETL) (160) and a cathode layer (190).

FIG. 4 is a schematic sectional view of an organic light-emitting diode (OLED) 100, according to an exemplary embodiment of the present invention. The OLED 100 includes a substrate (110), an anode layer (120), a hole injection layer (130), a hole transport layer (HTL) (140), an electron blocking layer (EBL) (145), wherein the hole transport layer (HTL) (140) and/or the electron blocking layer (EBL) (145) are a semiconductor layer comprising a compound of Formula (1), an emission layer (EML) (150), a hole blocking layer (HBL) (155), an electron transport layer (ETL) (160), an optional electron injection layer (EIL) (180), and a cathode layer (190).

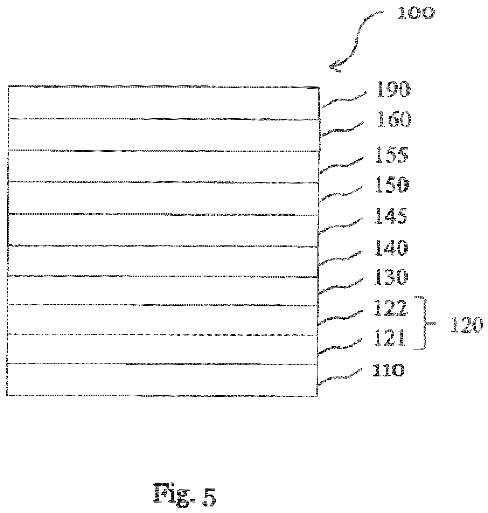

FIG. 5 is a schematic sectional view of an organic light-emitting diode (OLED) 100, according to an exemplary embodiment of the present invention. The OLED 100 includes a substrate (110), an anode layer (120) that comprises a first anode sub-layer (121) and a second anode sub-layer (122), a hole injection layer (130), a hole transport layer (HTL) (140), an electron blocking layer (EBL) (145), wherein the hole transport layer (HTL) (140) and/or the electron blocking layer (EBL) (145) are a semiconductor layer comprising a compound of Formula (1), an emission layer (EML) (150), a hole blocking layer (EBL) (155), an electron transport layer (ETL) (160) and a cathode layer (190).

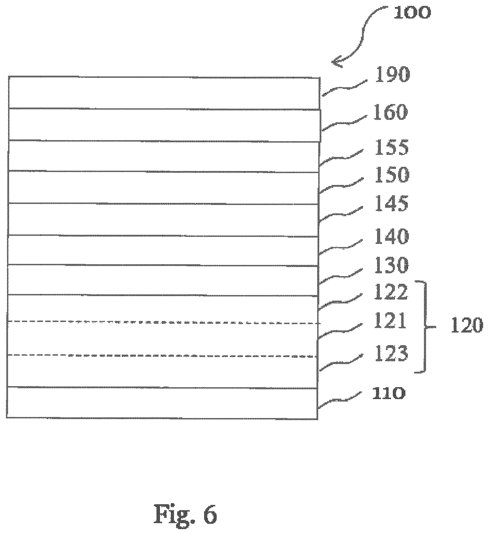

FIG. 6 is a schematic sectional view of an organic light-emitting diode (OLED) 100, according to an exemplary embodiment of the present invention. The OLED 100 includes a substrate (110), an anode layer (120) that comprises a first anode sub-layer (121), a second anode sub-layer (122) and a third anode sub-layer (123), a hole injection layer (130), a hole transport layer (HTL) (140), an electron blocking layer (EBL) (145), wherein the hole transport layer (HTL) (140) and/or the electron blocking layer (EBL) (145) are a semiconductor layer comprising a compound of Formula (1), an emission layer (EML) (150), a hole blocking layer (EBL) (155), an electron transport layer (ETL) (160) and a cathode layer (190). The layers are disposed exactly in the order as mentioned before.

In the description above the method of manufacture an organic electronic device 101 of the present invention is for example started with a substrate (110) onto which an anode layer (120) is formed, on the anode layer (120), a semiconductor layer comprising compound of formula (1) (140, 145), a photoactive layer (151) and a cathode electrode 190 are formed, exactly in that order or exactly the other way around.

In the description above the method of manufacture an OLED 100 of the present invention is started with a substrate (110) onto which an anode layer (120) is formed, on the anode layer (120), a hole injection layer (130), a hole transport layer (HTL) (140), optionally an electron blocking layer (EBL) (145), wherein the hole transport layer (HTL) (140) and/or the electron blocking layer (EBL) (145) are a semiconductor layer comprising a compound of Formula (1), an emission layer (150), optional a hole blocking layer (155), optional an electron transport layer (160), optional an electron injection layer (180), and a cathode electrode 190 are formed, exactly in that order or exactly the other way around.

The semiconductor layer comprising a compound of Formula (1) to (3) or (5) (130) can be a hole transport layer and/or an electron blocking layer.

While not shown in Fig. 1 to Fig. 6, a capping layer and/or a sealing layer may further be formed on the cathode electrodes 190, in order to seal the OLEDs 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

### DETAILED DESCRIPTION

The invention is furthermore illustrated by the following examples which are illustrative only and non-binding.

### Synthesis of compounds

### Synthesis of 14-phenyl-9,14-dibydrodibenzo[2,3:6,7]azpino[4,5-b]indole (Int-1)

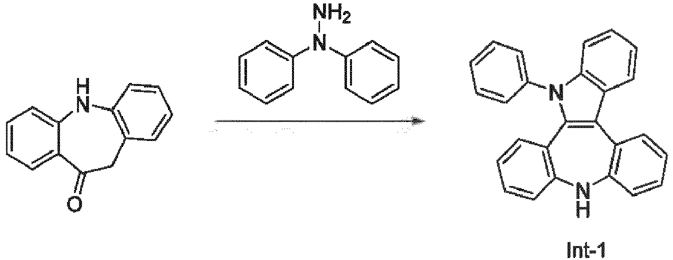

Under a nitrogen atmosphere 5H-dibenzo [b, f] azepin-10 (11H)-one (52.9 g, 252.6 mmol), N, N-diphenylhydrazine (51.2 g, 277.9 mmol) and acetic acid (500 mixing ml) and stirred for 12 hours at 120°C. After the reaction was terminated, the organic layer was extracted by dichloromethane. The extracted organic layer was filtered with the MgSO₄. The obtained organic compound after removal solvent was purified by column chromatography (Hexane: MC = 4:1 (v/v)) and 14-phenyl-9,14-dihydrodibenzo[2,3:6,7]azepino[4,5-b]indole (Int-1) was obtained (66.1 g, yield 73%).

### Synthesis of 9-(3-bromophenyl)-14-phenyl-9,14-dihydrodibenzo[2,3:6,7]azepino[4,5-b]indole (Int-2)

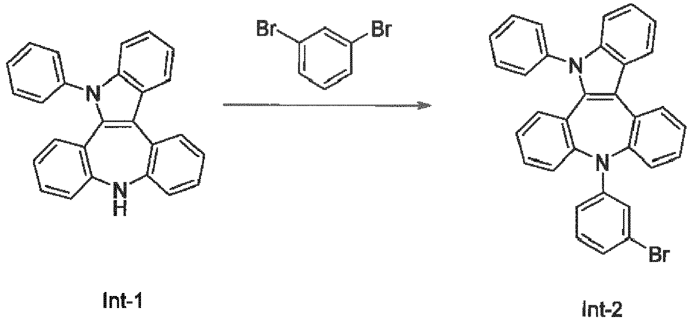

Under a nitrogen stream Int-i (2.4 g, 6.7 mmol), 1,3-dibromobenzene (1.89 g, 8.0 mmol), Pd(OAc)₂ (0.08 g, 0.34 mmol), P(*t*-Bu)₃ (0.16 ml, 0.67 mmol), NaO (*t*-Bu) (1.29 g, 13.4 mixing mmol) and toluene (70 ml) and stirred for 5 hours at 110 °C. After the reaction was terminated, the organic layer was extracted, and then was filtered with the MgSO₄. The obtained organic compound after removal solvent was purified by recrystallization, and 9-(3-bromophenyl)-14-phenyl-9,14-dihydrodibenzo[2,3: 6,7]azepino[4,5-b]indole (Int-2) was obtained (2.24 g, yield 65%).

### Synthesis of 9-(phenanthren-9-yl)phenyl)-14-phenyl-9,14-dihydrodibenzo[2,3:6,7]azepino[4,5-b]indole (A12)

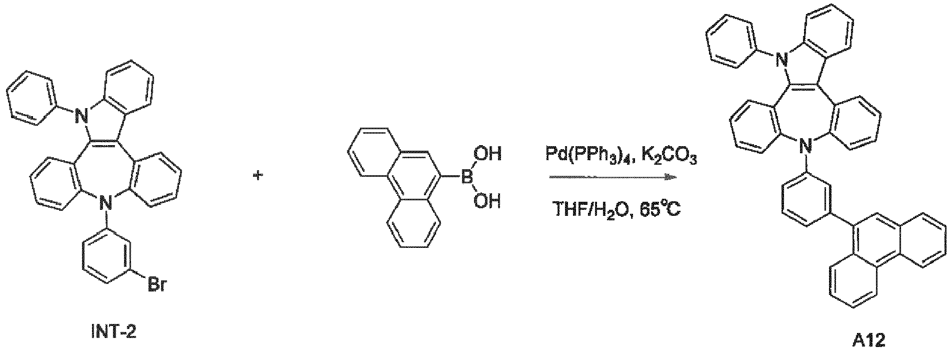

A flask was flushed with nitrogen and charged with 9-(3-bromophenyl)-14-phenyl-9,14-dihydrodibenzo[2,3:6,7]azepino[4,5-b]indole (25.67g, 1.0eq, 50mmol), phenanthren-9-ylboronic acid (11.38g, 1.025eq, 51.25mmol; CAS [68572-87-2]; commercially available from Sphinx), tetrakis(triphenylphophine)palladium(o) (1.16g, 0.02eq, immol), and potassium carbonate (13.82g, 2.0eq, 100mmol). A mixture was stirred in toluene (200mL) with water (50mL) overnight at 65□. Then, it was cooled down to room temperature. The organic layer was decanted and dried over MgSO₄. The drying agent was filtered off, and the solvent in the organic phase were evaporated under vacuum. The crude product was dissolved in toluene (200mL), and then the resulting solution was filtered over silica using toluene as eluent. The organic solution was evaporated under vacuum, and acetone (300mL) was added. And then the suspension was stirred at room temperature till precipitation. The solid was filtered, rinsed with acetone and dried overnight at 60□ under vacuum, 25.8g of crude product was obtained. Further purification was achieved by means of gradient sublimation (sublimation yield 88%, HPLC purity 99.75% after sublimation).

### Synthesis of 14-phenyl-9-(5'-phenyl-[1,1':3',1"-terphenyl]-3-yl)-9,14-dihydrodibenzo[2,3:6,7]azepino[4,5-b]indole (A13)

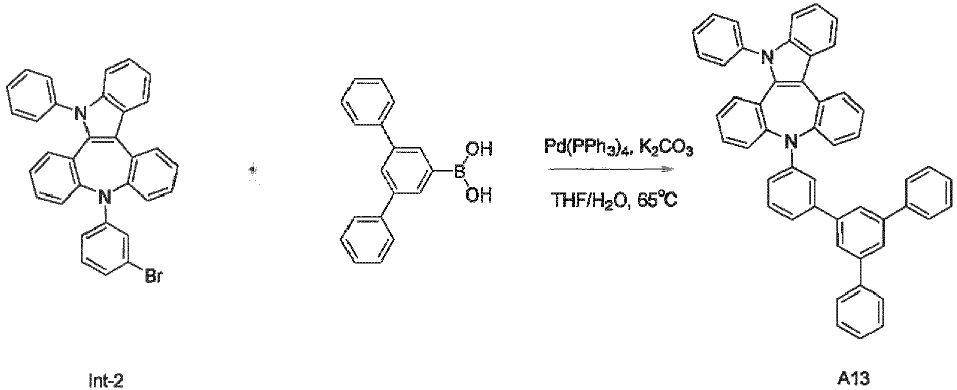

A flask was flushed with nitrogen and charged with 9-(3-bromophenyl)-14-phenyl-9,14-dihydrodibenzo[2,3:6,7]azepino[4,5-b]indole (25.67g, 1.0eq, 50mmol), [1,1':3',1"-terphenyl]-5'-ylboronic acid (14.05g, 1.025eq, 51.25mmol; CAS [128388-54-5]; commercially available from Green Guardee), tetrakis(triphenylphophine)palladium(o) (1.73g, 0.03eq, 1.5mmol), and potassium carbonate (13.82g, 2.0eq, 100mmol). A mixture was stirred in toluene (200mL) with water (50mL) overnight at 65□. Then, it was cooled down to room temperature. The organic layer was decanted and dried over MgSO₄. The drying agent was filtered off, and the solvent in the organic phase were evaporated under vacuum. The crude product was dissolved in toluene (200mL), and then the resulting solution was filtered over silica using toluene as eluent. The organic solution was evaporated under vacuum, and acetone (300mL) was added. And then the suspension was stirred at room temperature till precipitation. The solid was filtered, rinsed with acetone and dried overnight at 60□ under vacuum, 21.9g of crude product was obtained. Further purification was achieved by means of gradient sublimation (sublimation yield 91%, HPLC purity 99.66% after sublimation).

### Synthesis of 14-phenyl-9-(3-(9-phenyl-9H-carbazol-3-yl)phenyl)-9,14-dihydrodibenzo[2,3:6,7]azepino4,5-b]indole (A2))

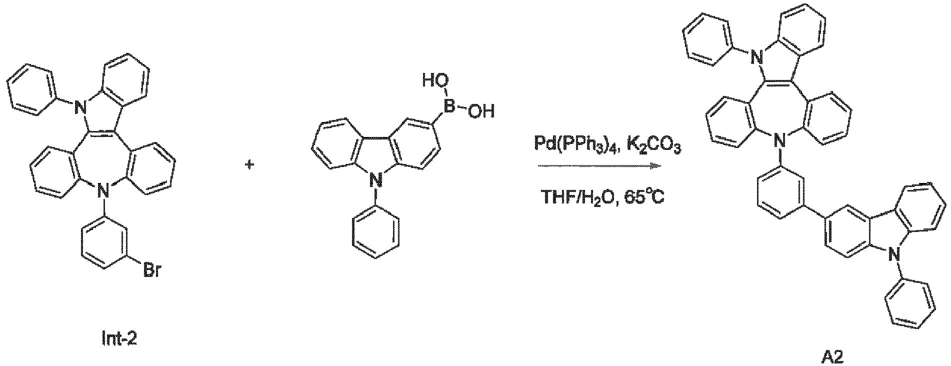

A flask was flushed with nitrogen and charged with 9-(3-bromophenyl)-14-phenyl-9,14-dihydrodibenzo[2,3:6,7]azepino[4,5-b]indole (25.67g, 1.0eq, 50mmol), (9-phenyl-9H-carbazol-3-yl)boronic acid (17.23g, 1.2eq, 60.00mmol; CAS [854952-58-2]; commercial available from T&W), tetrakis(triphenylphophine)palladium(o) (1.16g, 0.02eq, 1mmol), and potassium carbonate (13.82g, 2.0eq, 100mmol). A mixture was stirred in toluene (200mL) with water (50mL) overnight at 65□. Then, it was cooled down to room temperature. The organic layer was decanted and dried over MgSO₄. The drying agent was filtered off, and the solvent in the organic phase were evaporated under vacuum. The crude product was dissolved in toluene (200mL), and then the resulting solution was filtered over silica using toluene as eluent. The organic solution was evaporated under vacuum, and acetone (300mL) was added. And then the suspension was stirred at room temperature till precipitation. The solid was filtered, rinsed with acetone and dried overnight at 60□ under vacuum, 25.4g of crude product was obtained. Further purification was achieved by means of gradient sublimation (sublimation yield 87%, HPLC purity 99.98% after sublimation).

### Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

### General procedure for fabrication of OLEDs

For bottom emission devices, a 15Ω/cm2 glass substrate with 90 nm ITO (available from Corning Co.) was cut to a size of 50 mm x 50 mm x 0.7 mm, ultrasonically washed with isopropyl alcohol for 5 minutes and then with pure water for 5 minutes, and washed again with UV ozone for 30 minutes, to prepare the anode. Then, a compound of formula (1) or 9-(4-(naphthalen-1-yl)phenyl)-10-(naphthlen-2-yl)anthracene (NPNA) and a metal complex B1 or B2 were co-deposited in vacuum on the anode layer, to form a hole injection layer (HIL) having a thickness of 10 nm. The composition of the HIL can be seen in Table 2.

Then, 9-(4-(naphthalen-1-yl)phenyl)-10-(naphthlen-2-yl)anthracene (NPNA) or a compound of formula (1) was vacuum deposited on the HIL, to form a HTL having a thickness of 128 nm.

The formula of the substantially covalent matrix compound in the HTL was identical to the substantially covalent matrix compound used in the HIL.

Then a compound of formula (1) or no compound was vacuum deposited on the HTL, to form an electron blocking layer (EBL) having a thickness of 5 nm.

Then 97 vol.-% Ho9 (Sun Fine Chemicals, Korea) as EML host and 3 vol.-% BD200 (Sun Fine Chemicals, Korea) as fluorescent blue emitter dopant were deposited on the EBL, to form a blue-emitting first emission layer (EML) with a thickness of 20 nm.

Then a hole blocking layer was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML.

Then the electron transporting layer having a thickness of 31 nm was formed on the hole blocking layer by depositing 50 wt.-% 2-(2',6'-diphenyl-[1,1':4',1"-terphenyl]-4-yl]-4-phenyl-6-(3-(pyridine-4-yl)phenyl)-1,3,5-triazine and 50 wt.-% of LiQ.

Then Al was evaporated at a rate of 0.01 to 1 Å/s at 10-7 mbar to form a cathode layer with a thickness of 100 nm on the electron transporting layer.

The metal complex used have the following structure:

| | |
|---|---|
| 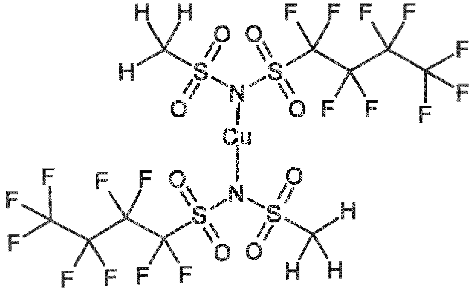 | 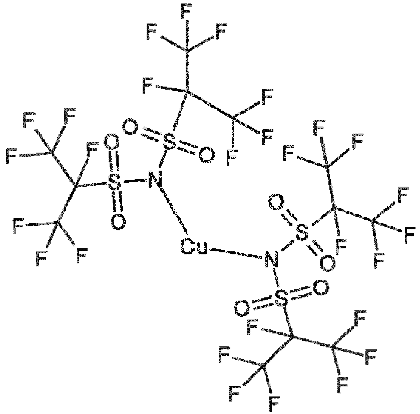 |
| B-1 | B-2 |

To assess the performance of the inventive examples compared to the prior art, the current efficiency is measured at 20°C. The current-voltage characteristic is determined using a Keithley 2635 source measure unit, by sourcing an operating voltage U in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values. The cd/A efficiency at 10 mA/cm² is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 10 mA/cm².

In top emission devices, the emission is forward directed, non-Lambertian and also highly dependent on the mircocavity. Therefore, the efficiency EQE will be higher compared to bottom emission devices. To determine the efficiency EQE in % the light output of the device is measured using a calibrated photodiode at 10 mA/cm².

Lifetime LT of the device is measured at ambient conditions (20°C) and 30 mA/cm², using a Keithley 2400 sourcemeter, and recorded in hours. The brightness of the device is measured using a calibrated photo diode. The lifetime LT is defined as the time till the brightness of the device is reduced to 97 % of its initial value.

To determine the voltage stability over time U(50h)-(1h), a current density of at 30 mA/cm2 was applied to the device. The operating voltage was measured after 1 hour and after 50 hours, followed by calculation of the voltage stability for the time period of 1 hour to 50 hours.

### Technical Effects of the invention

In Table 1, HOMO levels, LUMO levels, and dipole moment are shown for inventive compounds A1 to A14. LUMO levels were calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

**Table 1:**

| Compound | Structure | HOMO [eV] | LUMO [eV] | Dipole moment [debye] |
|---|---|---|---|---|
| A1 | 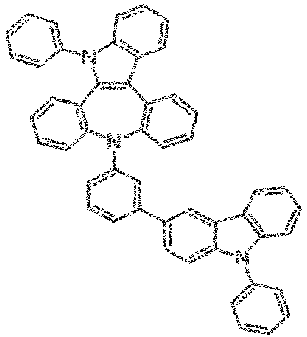 | -5.08 | -1.07 | 1.90 |
| A2 | 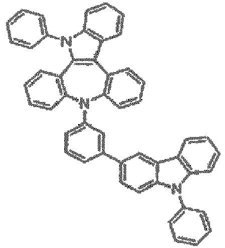 | -5.01 | -1.05 | 3.80 |
| A3 | 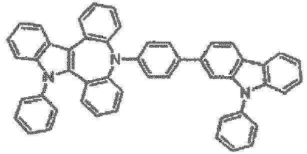 | -4.81 | -1.12 | 2.55 |
| A4 | 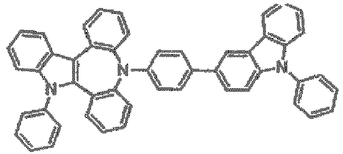 | -4.73 | -1.08 | 1.09 |
| A5 | 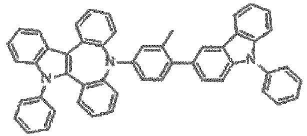 | -4.81 | -1.06 | 1.26 |
| A6 | 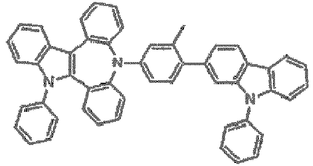 | -4-77 | -1.01 | 3.18 |
| A7 | 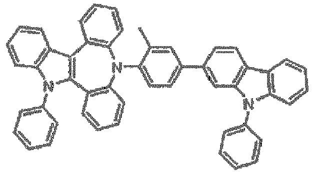 | -4.80 | -1.05 | 3.41 |
| AS | 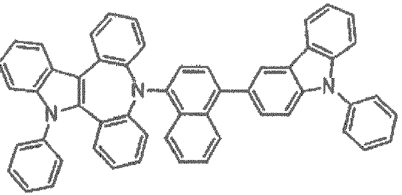 | -4.77 | -1.02 | 2.77 |
| A9 | 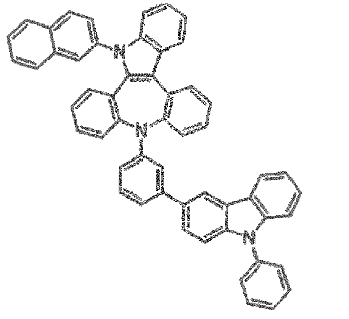 | -5.03 | -1.26 | 3.84 |
| A10 | 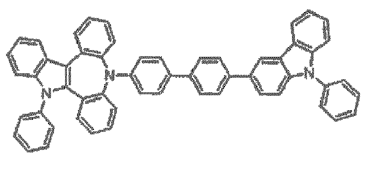 | -4.81 | -1.11 | 3.13 |
| A11 | 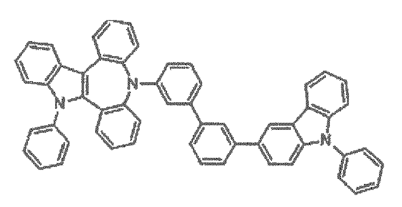 | -5.09 | -1.07 | 3.42 |
| A12 | 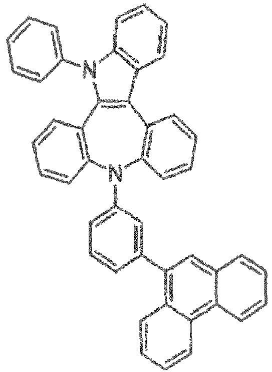 | -5.07 | -1.07 | 2.42 |
| A13 | 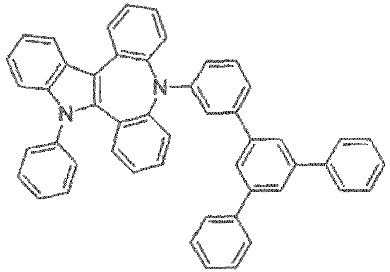 | -5.07 | -1.07 | 2.42 |
| A14 | 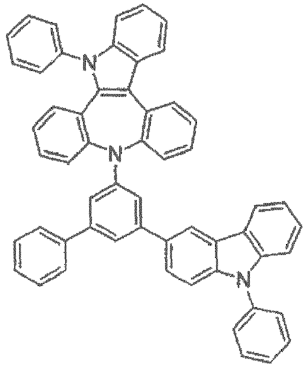 | -5.05 | 1.06 | 4.08 |

**Table 2: Performance of organic electronic devices comprising compound of formula (I) in the HTL**

| | **Concentration of dopant [Vol%]** | **Dopant** | **Matrix compound** | **HTL** | **EBL** | **EQE at 10 mA/cm² [%]** | **Voltage U at 10 mA/cm² [V]** |
|---|---|---|---|---|---|---|---|
| Inventive example | 10 | B2 | A2 | A2 | --- | 9.57 | 3.68 |
| Inventive example | 26 | B2 | A2 | A2 | --- | 9.56 | 3.67 |
| Inventive example | 26 | B2 | A12 | A12 | --- | 9.38 | 4.02 |
| Inventive example | 10 | B2 | A13 | A13 | --- | 10.01 | 3.94 |
| Inventive example | 26 | B2 | A13 | A13 | --- | 10.03 | 3.92 |
| Inventive example | 25 | B1 | NPNA | NPNA | A2 | 9.32 | 3.82 |

In all devices, the external quantum efficiency (EQE) is high and the operating voltage is low.

A low operating voltage may be beneficial for reduced power consumption and improved battery life, in particular in mobile devices.

A high EQE may be beneficial for reduced power consumption and improved battery life, in particular in mobile devices.

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. An organic electroluminescent device comprising an anode layer, a cathode layer, a hole injection layer, at least one light-emitting layer and an organic semiconductor layer; wherein the organic semiconductor layer is arranged between the hole injection layer and the at least one light-emitting layer;
wherein
- the organic semiconductor layer comprises a compound of formula (1) 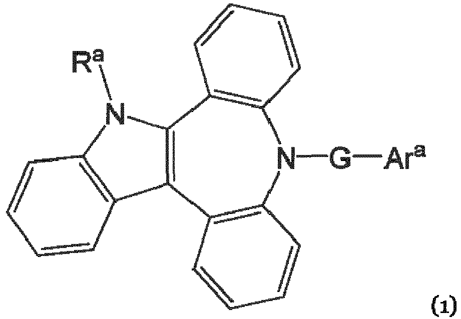
- R^{a} is selected from a substituted or unsubstituted C₆ to C₁₈ aryl, or a substituted or unsubstituted C₁ to C₁₈ alkyl;
- G is selected from a substituted or unsubstituted C₆ to C₁₂ aryl;
- Ar^{a} is selected from a substituted or unsubstituted C₁₃ to C₂₄ aryl comprising 0 to 3 fused rings; a group of formula (2a); or a group of formula (2b); 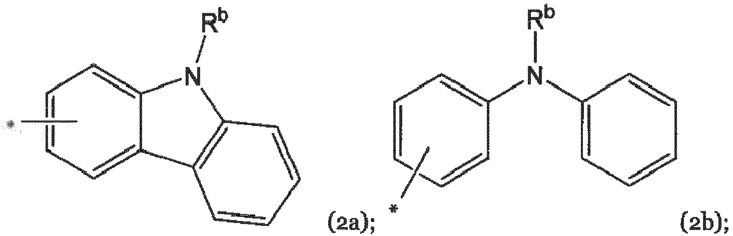
- R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl; and
- the hole injection layer comprises hole injection material and a matrix material.

2. The organic electroluminescent device according to claim 1, wherein R^{a} is selected from an unsubstituted C₆ to C₁₂ aryl, or an unsubstituted C₁ to C₄ alkyl.

3. The organic electroluminescent device according to any of the claims 1 or 2, wherein G is selected from a substituted or unsubstituted C₆ to C₁₂ aryl, wherein, if G is substituted, the one or more substituents are independently selected from C₁ to C₁₂ alkyl, C₆ to C₁₂ aryl or C₃ to C₁₂ heteroaryl.

4. The organic electroluminescent device according to any of the claims 1 to 3, wherein Ar^{a} is selected from a substituted or unsubstituted C₁₃ to C₁₈ aryl comprising 0 to 3 fused rings, wherein, if the C₁₃ to C₁₈ aryl comprising 0 to 3 fused rings is substituted, the one or more substituents are independently selected from C₁ to C₁₂ alkyl, C₆ to C₁₂ aryl or C₃ to C₁₂ heteroaryl; a group of formula (2a); or a group of formula (2b); 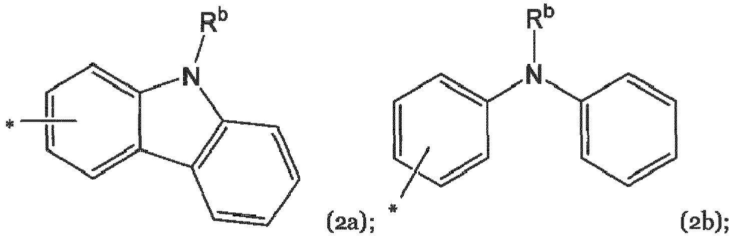 wherein in formula (2a) and formula (2b) R^{b} is selected from an unsubstituted C₆ to C₁₈ aryl; or an unsubstituted C₁ to C₄ alkyl.

5. The organic electroluminescent device according to any of the claims 1 to 4, wherein the hole injection material comprises a compound of formula (3) and/or a compound of formula (4)
M^{n⊕} (L^{Θ})ₙ (3)
wherein in formula (3)
- M is a metal ion;
- n is the valency of M, and n is an integer from 1 to 4; and
- L is a ligand comprising at least two carbon atoms; 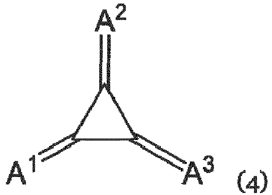 wherein in formula (4)
- A¹, A² and A³ are independently selected from a group (4a) 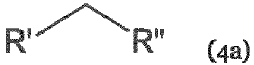
- each R' is independently selected from substituted or unsubstituted C₆ to C₃₆ aryl and substituted or unsubstituted C₂ to C₃₆ heteroaryl;
- if R' is substituted, the one or more substituents are independently selected from an electron-withdrawing group, preferably from F, CN, NO₂, perfluorinated alkyl, most preferred CF₃; and
- each R" is independently selected from an electron-withdrawing group, preferably from CN, or perfluorinated alkyl, preferably from CF₃, NO₂, or F.

6. The organic electroluminescent device according to claim 5, wherein in formula (3) M is selected from Li, Na, K, Cs, Mg, Mn, Cu, Fe, Zn, Ag, Bi, or Mo.

7. The organic electroluminescent device according to any of the claims 5 or 6, wherein in formula (3) L is independently selected from a compound of the formula (10) 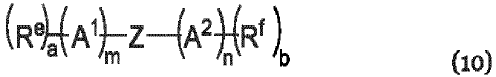 wherein
- m, and n are independently selected from 0, 1;
- m+n≥1;
- a, and b are independently selected from 0, 1;
- a+b≥1;
- Z is selected from CR^{g}, N, or O;
- if Z is O then a is o when m is ο or b is ο when n is o;
- R^{g} is selected from H, D, CN, substituted or unsubstituted aryl, substituted or unsubstituted heteroaryl, substituted or unsubstituted alkyl, substituted or unsubstituted carbocyclyl, or substituted or unsubstituted heterocyclyl;
- A¹ and A² are independently selected from C=O, C-O, or SO₂;
- A¹ and A² together can form a cycle with Z;
- R^{e} and R^{f} are independently selected from substituted or unsubstituted aryl, substituted or unsubstituted heteroaryl, substituted or unsubstituted alkyl, substituted or unsubstituted carbocyclyl, or substituted or unsubstituted heterocyclyl; and
- L is monoanionic.

8. The organic electroluminescent device according to any of the claims 1 to 7, wherein the matrix material comprises a compound of formula (6), a compound of formula (7); a compound of formula (8), a compound of formula (11) or mixtures thereof 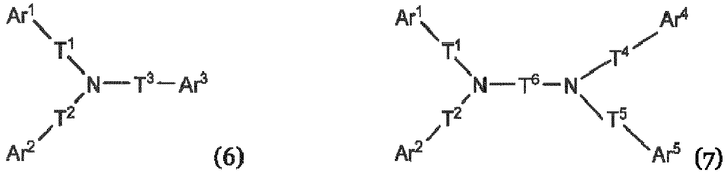 wherein in formulas (6) and (7)
- T¹, T², T³, T4 and T⁵ are independently selected from a single bond, phenylene, biphenylene, terphenylene or naphthenylene, preferably a single bond or phenylene;
- T⁶ is phenylene, biphenylene, terphenylene or naphthenylene;
- Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, preferably from substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are independently selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
- If one or more of Ar¹, Ar², Ar³, Ar⁴ and Ar⁵ is/are substituted, the one ore more substituents is/are independently selected from H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle, wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl; 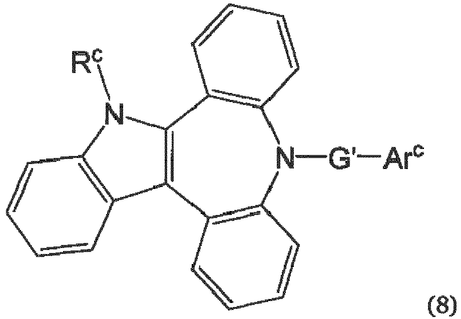 wherein in formula (8)
- R^{c} is selected from substituted or unsubstituted aryl, substituted or unsubstituted heteroaryl, substituted or unsubstituted alkyl;
- G' is selected from a substituted or unsubstituted C₆ to C₁₈ aryl and C₃ to C₁₈ heteroaryl; and
- Ar^{c} is selected from a substituted or unsubstituted C₆ to C₂₄ aryl comprising 0 to 3 fused rings; a or C₃ to C₂₄ heteroaryl comprising 0 to 3 fused rings; or a group of formula (9a); or a group of formula (9b) 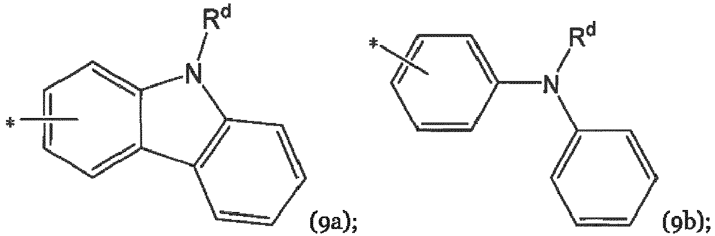 and
- In formula (9a) and formula (9b) R^{b} is selected from a substituted or unsubstituted C₆ to C₃₆ aryl; a substituted or unsubstituted C₂ to C₃₆ heteroaryl; or a substituted or unsubstituted C₁ to C₁₈ alkyl;
- (Ar^{1'})ᵣ-(Ar^{2'})ₛ-Ar^{3'}-(Ar^{4'})ₚ-(Ar^{5'})_{q}-(Ar^{6'})ᵣ (11),
- wherein in formula (11)
- k, s, q, r are independently selected from each other 0, 1 or 2,
- p is 1, 2 or 3,
- wherein 2 ≤ k+s+q+r+p ≤ 11,
- Ar^{1'} to Ar^{6'} are independently selected from a substituted or unsubstituted unsaturated 5- to 7-member ring of a heterocycle, a substituted or unsubstituted C₆ to C₃₀ aryl, a substituted or unsubstituted C₃ to C₃₀ heteroaryl, a substituted or unsubstituted fluorene, or a fused ring system comprising 2 to 6 substituted or unsubstituted 5- to 7-member rings and the rings are independently selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle; preferably independently selected from substituted or unsubstituted biphenylene, substituted or unsubstituted fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted or unsubstituted azepine, substituted or unsubstituted dibenzo[b,f]azepine, 9,9'-spirobi[fluorene], substituted or unsubstituted spiro[fluorene-9,9'-xanthene], substituted or unsubstituted 9,14-dihydrodibenzo[2,3:6,7]azepino[4,5-b]indole, or a substituted or unsubstituted aromatic fused ring system comprising at least three substituted or unsubstituted aromatic rings independently selected from the group comprising substituted or unsubstituted non-hetero, substituted or unsubstituted hetero 5-member rings, substituted or unsubstituted 6-member rings and/or substituted or unsubstituted 7-member rings,
- wherein the substituents are selected from the group H, D, C₁ to C₁₂ alkyl, unsubstituted C₆ to C₁₈ aryl, unsubstituted C₃ to C₁₈ heteroaryl, a fused ring system comprising 2 to 6 unsubstituted 5- to 7-member rings and the rings are independently selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

9. The organic electroluminescent device according to any of the claims 1 to 8, wherein the hole injection layer is free of copper phthalocyanine.

10. The organic electroluminescent device according to any of the claims 1 to 9, wherein the compound of formula (1) is represented by one of the formulas A1 to A14
| | | |
|---|---|---|
| 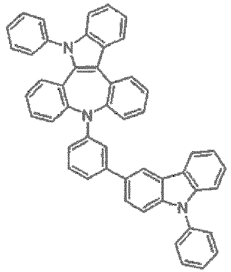 | 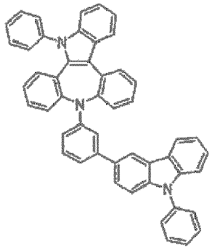 | 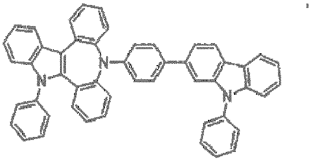 |
| A1 | A2 | A3 |
| 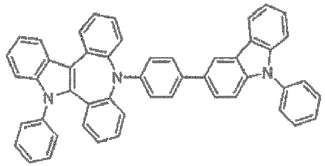 | 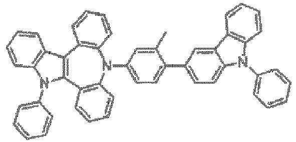 | 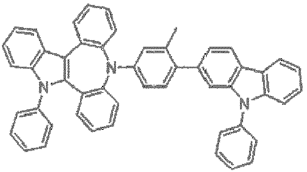 |
| A4 | A5 | A6 |
| 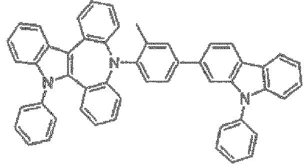 | 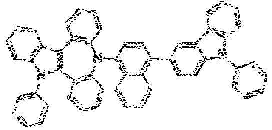 | 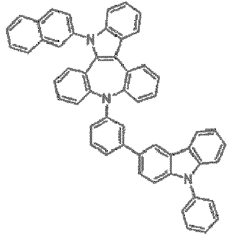 |
| A7 | A8 | A9 |
| 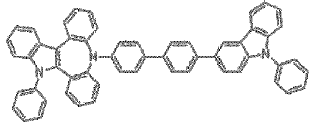 | 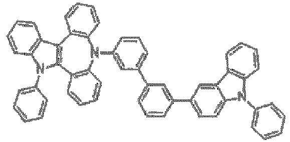 | 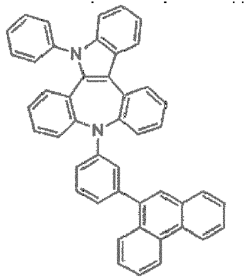 |
| A10 | A11 | A12 |
| 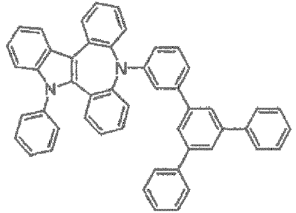 | 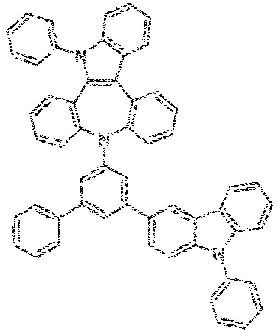 | |
| A13 | A14 | |

11. The organic electroluminescent device according to any of the claims 1 to 10, wherein the organic electroluminescent device further comprises a hole transport layer, wherein the hole transport layer is the organic semiconductor layer.

12. The organic electroluminescent device according to any of the claims 1 to 11, wherein the organic electroluminescent device further comprises an electron blocking layer, wherein the electron blocking layer is the organic semiconductor layer.

13. The organic electroluminescent device according to any of the claims 1 to 12, wherein the organic electroluminescent device further comprises a hole transport layer and an electron blocking layer, wherein both the hole transport layer and the electron blocking layer are the organic semiconductor layer.

14. The organic electroluminescent device according to claim 13, wherein the hole injection layer comprises a compound of formula (1).

15. A compound of formula (1a) 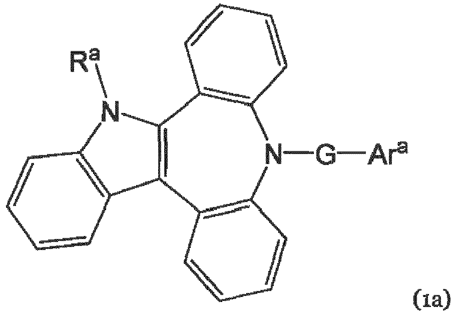 wherein
- R^{a} is selected from an unsubstituted C₆ to C₁₂ aryl, or an unsubstituted C₁ to C₁₈ alkyl;
- G is selected from a substituted or unsubstituted C₆ to C₁₂ aryl;
- Ar^{a} is selected from a substituted or unsubstituted C₁₃ to C₂₄ aryl comprising 0 to 3 fused rings, wherein, if the C₁₃ to C₂₄ aryl comprising 0 to 3 fused rings is substituted, the one or more substituents are independently selected from C₁ to C₁₈ alkyl, or C₆ to C₁₂ aryl; a group of formula (2c); or a group of formula (2d);
- 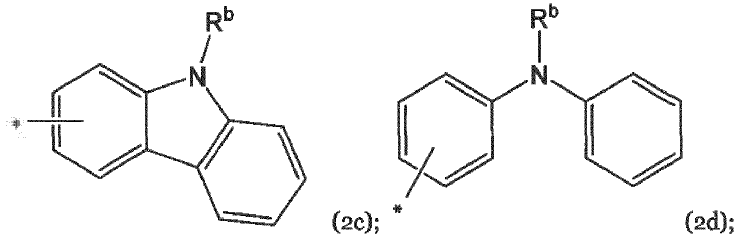 and
- R^{b} is selected from an unsubstituted C₆ to C₃₆ aryl; or an unsubstituted C₁ to C₁₈ alkyl.
